# EUROPEAN PATENT APPLICATION

(11) **EP 2 543 466 A1**
(43) Date of publication of application: **09.01.2013**
(21) Application number: 11765652.0
(22) Date of filing: 30.03.2011
(51) Int. Cl.: B23K 26/36, B23K 26/00, B23K 26/04, B23K 26/40, H01L 23/15, H01L 23/52, H05K 3/40, H05K 3/00

(54) **METHOD OF FORMING MICROSTRUCTURES, LASER IRRADIATION DEVICE, AND SUBSTRATE**

(30) Priority: 08.04.2010 JP 2010089509
(71) Applicant: Fujikura, Ltd., Tokyo 135-8512 (JP)
(72) Inventor: WAKIOKA Hiroyuki, Sakura-shi Chiba 285-8550 (JP)
(74) Representative: Cabinet Plasseraud
(86) International application number: PCT/JP2011/058033
(87) International publication number: WO 2011/125752

(57) **Abstract**

A method of forming a microstructure includes a Step (A) of forming a modified region in a substrate by irradiating a laser beam having a pulse duration on the order of picoseconds or shorter on a region where a pore-like microstructure is to be provided, and scanning a focal point at which the laser beam is converged; and a Step (B) of forming a microstructure by performing an etching process on the substrate in which the modified region has been formed, and removing the modified region, where a linear polarized laser beam is used as the laser beam in the Step (A), and the laser beam is irradiated so that an orientation of a linear polarization has a certain direction with respect to a direction of scanning the focal point.

## Description

### TECHNICAL FIELD

The present invention relates to a method of a forming microstructure in a substrate using a laser beam, a laser irradiation device that is used in this method, a substrate that is manufactured using this method and a substrate having a micro hole. More particularly, it relates to a method of forming a micro hole in a substrate using a laser beam, a laser irradiation device that is used in this method, and a substrate that is manufactured using this method and a substrate that has a micro hole.
Priority is claimed on Japanese Patent Application No. 2010-089509, filed April 8, 2010, the content of which is incorporated herein by reference.

### BACKGROUND ART

Conventionally, as a method of electrically connecting a plurality of devices that are mounted on one principal surface and another principal surface of a substrate, a method is used that forms micro holes that penetrates both main surfaces of the substrate and microstructures such as micro grooves or the like in a portion near the substrate surface, and moreover provides interconnections in which an electrically conductive substance is filled in the micro holes and micro grooves. For example, Patent Document 1 given below discloses an interposer substrate that is provided with through-hole interconnections that are formed by filling an electrically conductive substance in micro holes that have a portion that extends in a direction differing from the thickness direction of the substrate.

As a method that forms a microstructure such as a micro hole and a micro groove in this kind of interconnection substrate, there is known a method that, after having modified a portion of the substrate such as glass using a laser, removes the modified region using etching. Specifically, first, using a femtosecond laser as a light source, this laser is irradiated on the substrate, and with the laser focal point converged on the location to be modified in the substrate, this focal point is moved to scan the region to be modified. Thereby, a modified region having a predetermined shape is formed in the substrate. Next, with a wet etching method that immerses the substrate in which the modified region is formed in a predetermined chemical solution, this modified region is removed from the inside of the substrate, whereby microstructures such as micro holes or micro grooves are formed.

### PRIOR ART DOCUMENT

### PATENT DOCUMENT

[Patent Document 1] Japanese Unexamined Patent Application, First Publication No. 2006-303360

### DISCLOSURE OF INVENTION

### PROBLEMS TO BE SOLVED BY THE INVENTION

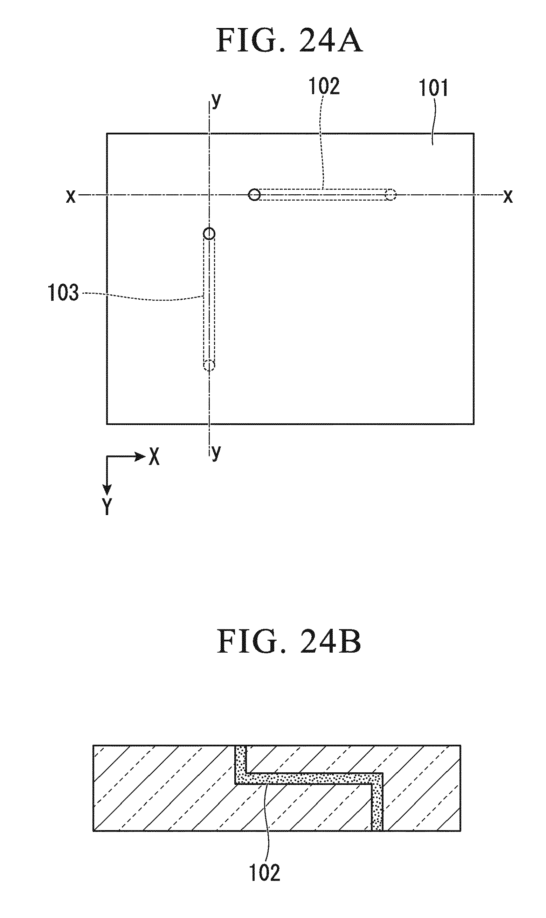

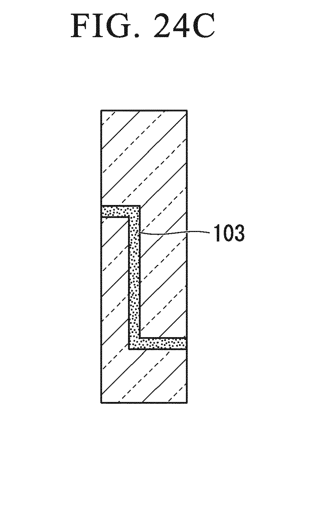

In the conventional method, when removing modified regions from a substrate by wet etching, even when the shapes of the modified regions have comparable complexity, there has been the problem of the ease of etching (etching speed) differing among micro holes whose placement differs in the substrate. For example, in the substrate 101 shown in FIG. 24, a first modified region 102 is easily etched, but a second modified region 103 is etched with difficulty, and so the etching time becomes longer. For this reason, there has been the problem in which, by the time the etching of the modified region 103 is completed, etching of a non-modified region at which the laser has not been irradiated has excessively advanced.

The present invention was achieved in view of the above circumstances, and has as its object to provide a method of forming a microstructure such as a micro hole with nearly a constant etching speed without being affected by their placement in a substrate, a laser irradiation device that is used in this formation method, and a substrate that is manufactured using this formation method and a substrate that has a micro hole.

### MEANS FOR SOLVING THE PROBLEMS

(1) The method of forming a microstructure according to a first aspect of the present invention is a method of forming a microstructure including a Step (A) of forming a modified region in a substrate by irradiating a laser beam having a pulse duration on the order of picoseconds or shorter on a region where a pore-like microstructure is to be provided, and scanning a focal point at which the laser beam is converged; and a Step (B) of forming a microstructure by performing an etching process on the substrate in which the modified region has been formed, and removing the modified region, wherein: a linear polarized laser beam is used as the laser beam in the Step (A); and the laser beam is irradiated so that an orientation of a linear polarization has a certain direction with respect to a direction of scanning the focal point.
(2) In the method of forming a microstructure according to the aforementioned (1), the certain direction may be a direction that is perpendicular to the direction of scanning the focal point.
(3) A laser irradiation device according to the second aspect of the present invention includes a device that, when forming a modified region in a substrate by irradiating a linear polarized laser beam having a pulse duration on the order of picoseconds or shorter at a region where a pore-like microstructure is to be provided, and scanning a focal point at which the laser beam is converged, irradiates the laser beam so that an orientation of a linear polarization has a certain direction with respect to a direction of scanning the focal point.
(4) In the laser irradiation device of the aforementioned (3), the device may be a phase retarder, and the phase retarder, in response to a change in the scanning direction of the focal point, may function so as to cause the orientation of the linear polarization of the laser beam with respect to the scanning direction after the change to match a certain direction.
(5) In the laser irradiation device of the aforementioned (3) or (4), the device may be a substrate stage, and the substrate stage, in response to a change in the scanning direction of the focal point, may function so as to cause the orientation of the linear polarization of the laser beam with respect to the scanning direction after the change to match a certain direction.
(6) The substrate according to the third aspect of the present invention is a substrate that is manufactured using the method of forming a microstructure according to the aforementioned (1) or (2), including a section in which a banded uneven profile is formed on an inner wall surface of the microstructure.
(7) In the substrate of the aforementioned (6), the substrate may include a fluidic channel through which a fluid circulates in an interior thereof.
(8) The substrate according to the fourth aspect of the present invention is a substrate with a micro hole, with a banded uneven profile being formed along an extension direction of the micro hole at at least a portion of an inner wall surface of the micro hole.

### EFFECTS OF THE INVENTION

According to the method of forming a microstructure according to an aspect of the present invention, the laser irradiation is performed while keeping the orientation of the linear polarization of the laser beam in a certain direction with respect to the scanning direction of the laser beam. Thereby, it is possible to form easy to etch areas and hard to etch areas in a certain direction, alternating with respect to the scanning direction. That is to say, the easy to etch areas and hard to etch areas are formed in the same state at any position regardless of the position at which the modified region is formed in the substrate. That is to say, the ease of etching is of the same extent. For this reason, it is possible to form a microstructure at nearly a constant etching speed without being influenced by the arrangement or shape of the modified region in the substrate. Therefore, it is possible to accurately control the size of a microstructure such as a micro hole or the like.

In the case of performing laser irradiation while keeping the orientation of the linear polarization perpendicular with respect to the direction of scanning the focal point of the laser beam, it is possible to form the easy to etch areas and hard to etch areas in the modified region in which the microstructure is formed, running side-by-side and parallel with respect to the scanning direction. For this reason, it is possible to form a microstructure at a nearly constant etching speed, and moreover at the fastest etching speed without being influenced by the arrangement or shape of the modified region in the substrate. For this reason, it is possible to shorten the processing time while accurately controlling the size of a microstructure such as a micro hole or the like. The etching time of the modified region in which each microstructure is formed depends on the length of the modified region in which this microstructure is formed. The etching time of the modified region in which each microstructure is formed depends on the length of the modified region in which this microstructure is formed. Therefore, since it is possible to calculate the etching time at the design stage of the microstructure, production control is easy. Also, since the etching speed is fast, and the etching is completed in a short time, the non-modified region is not excessively etched, and it is possible to manufacture vias with a high aspect ratio.

Also, the laser irradiation device according to the aspect of the present invention has a device that maintains the orientation of the linear polarization that the laser beam has in a certain direction with respect to the scanning direction of the focal point of the laser beam. For this reason, in the modified region that is formed in a desired shape in this substrate, it is possible to form the easy to etch areas and hard to etch areas in a certain direction alternating with respect to the scanning direction. As a result, in the wet etching step that is separately performed, it is possible to remove this modified region at a nearly constant etching speed without being influenced by the arrangement or shape of the modified region in the substrate. Therefore, it is possible to accurately control the size of a microstructure such as a micro hole or the like that is to be formed.

Also, with the substrate that is manufactured using the method of forming a microstructure according to an aspect of the present invention, it is possible to provide a substrate that has a microstructure that is formed with an accurate shape in this substrate. Moreover, a section in which a banded uneven profile (stria) is formed is provided in the wall surface of the microstructure such as a micro hole or the like that is formed in this substrate.
Furthermore, it is possible to cause a fluid to flow into the microstructure such as a micro hole. In particular, in the case of having formed the microstructure while keeping the orientation of the linear polarization of the laser beam perpendicular to the direction of scanning the focal point of the laser beam, this fluid easily flows along the uneven profile in the wall surface of the microstructure. For this reason, there is the effect of making the inflow of this fluid smooth.

In the case of using this microstructure as a through-hole interconnection, by filling or forming a conductive substance in this microstructure, it is possible to provide an interconnection substrate that is provided with an interconnection that has a shape of high precision. Also, in the case of filling or forming a conductive substance in this microstructure, the adhesion between the conductive substance that has flowed into the microstructure and the substrate improves, due to the existence of a banded uneven profile. For this reason, it is possible to provide an interconnection substrate in which the conductive substance and the substrate are integrated in a stable manner.
Moreover, in the case of forming the microstructure while keeping the orientation of the linear polarization of the laser beam perpendicular to the direction of scanning the focal point of the laser beam, when filling or forming a conductive substance in this microstructure, the conductive substance flows into the microstructure along the banded uneven profile. For this reason, filling or forming this conductive substance becomes easy. Therefore, since it is possible to cause the conductive substance to smoothly flow in along the uneven profile, it is possible to uniformly fill or form the conductive substance in the microstructure.

Also, in the case of using the microstructure as a fluidic channel in which a fluid flows, since the banded uneven profile is provided along this fluidic channel, a fluid that flows within this fluidic channel easily flows along this banded uneven profile. For this reason, this fluid can smoothly flow through this fluidic channel.
In the case of the substrate having a micro hole that is used for a fluidic channel, it is possible to cause various fluids to flow in this micro hole (fluidic channel) in accordance with the object. For example, using the substrate as an interconnection substrate, a coolant such as air or water is circulated in this micro hole (fluidic channel). In this case, by this cooling function, it is possible to effectively lower the temperature rise of the substrate even when a device with a large heat value is mounted on this interconnection substrate. In addition, the substrate is used as a substrate that integrates a bio test system using micro-fluidics technology. In this case, it is possible to apply this micro hole (fluidic channel) to a fluidic channel that circulates biopolymer solutions, such as DNA (nucleic acid), protein materials, and lipids.

Also, with a substrate having a micro hole according to the aspect of the present invention, this substrate has a micro hole (through hole), and a banded uneven profile is formed along the extension direction of this micro hole at at least a portion of the inner wall surface of this micro hole. For this reason, the same effect is obtained as a substrate that is manufacturing using the method of forming a microstructure.

The advantageous effect, that is to say, in the case of using this substrate to manufacture an interposer substrate in which a conductive substance is filled or formed in this micro hole, is being able to make it an interconnection substrate in which the conductive substance and the substrate are integrated in a stable manner, due to the improvement in adhesion between the conductive substance that has flowed into the micro hole and the substrate. At this time, when filling or forming a conductive substance in this micro hole, the conductive substance smoothly flows inside the micro hole along the banded uneven profile. For this reason, the filling or forming of this conductive substance becomes easy, and it is possible to uniformly fill or form the conductive substance in the micro hole. Also, in the case of using the micro hole as a fluidic channel in which a fluid flows, a fluid that flows within this fluidic channel easily flows along this banded uneven profile along this fluidic channel. For this reason, this fluid can smoothly flow through this fluidic channel.

In accordance with the object, it is possible to cause various fluids to flow in the micro hole in a substrate that has the micro hole. For example, using the substrate as an interconnection substrate, a coolant such as air or water is circulated in this micro hole (fluidic channel). At this time, by this cooling function, it is possible to effectively lower the temperature rise of the substrate even when a device with a large heat value is mounted on this interconnection substrate. In addition, the substrate is used as a substrate that integrates a bio test system using micro-fluidics technology. In this case, it is possible to apply this micro hole (fluidic channel) to a fluidic channel that circulates biopolymer solutions, such as DNA (nucleic acid), protein materials, and lipids.

### BRIEF DESCRIPTION OF THE DRAWINGS

FIG. 1A is a plan view that shows an interconnection substrate according to the first embodiment of the present invention.
FIG. 1B is a cross-sectional view along line x1-x1 of FIG. 1A.
FIG. 1C is a cross-sectional view along line y-y of FIG. 1A.
FIG. 1D is a cross-sectional view along line x2-x2 of FIG. 1A.
FIG. 2A is a plan view showing an interconnection substrate according to the second embodiment of the present invention.
FIG. 2B is a cross-sectional view along line x1-x1 of FIG. 2A.
FIG. 2C is a cross-sectional view along line y1-y1 of FIG. 2A.
FIG. 2D is a cross-sectional view along line x2-x2 of FIG. 2A.
FIG. 2E is a cross-sectional view along line y2-y2 of FIG. 2A.
FIG. 3A is a plan view that shows the substrate in the method of forming a microstructure according to one embodiment of the present invention.
FIG. 3B is a cross-sectional view along line x1-x1 of FIG. 3A.
FIG. 3C is a cross-sectional view along line y-y of FIG. 3A.
FIG. 3D is a cross-sectional view along line x2-x2 of FIG. 3A.
FIG. 4A is a plan view that shows the substrate in the method of forming a microstructure according to one embodiment of the present invention.
FIG. 4B is a cross-sectional view along line x1-x1 of FIG. 4A.
FIG. 4C is a cross-sectional view along line y-y of FIG. 4A.
FIG. 4D is a close-up view of the region β of FIG. 4B.
FIG. 4E is a close-up view of the region γ of FIG. 4B.
FIG. 5A is a cross-sectional view along line x2-x2 of FIG. 4A that shows the substrate in the method of forming a microstructure according to one embodiment of the present invention.
FIG. 5B is a close-up view of FIG. 5A.
FIG. 6A is a plan view that shows the substrate in the method of forming a microstructure according to one embodiment of the present invention.
FIG. 6B is a cross-sectional view along line x1-x1 of FIG. 6A.
FIG. 6C is a cross-sectional view along line y-y of FIG. 6A.
FIG. 6D is a cross-sectional view along line x2-x2 of FIG. 6A.
FIG. 7A is a plan view that shows a substrate manufactured by the method of forming a microstructure according to one embodiment of the present invention.
FIG. 7B is a cross-sectional view along line x1-x1 of FIG. 7A.
FIG. 7C is a cross-sectional view along line y-y of FIG. 7A.
FIG. 7D is a cross-sectional view along line x2-x2 of FIG. 7A.
FIG. 8A is a plan view that shows the substrate in the method of forming a microstructure according to one embodiment of the present invention.
FIG. 8B is a cross-sectional view along line x1-x1 of FIG. 8A.
FIG. 8C is a cross-sectional view along line y1-y1 of FIG. 8A.
FIG. 8D is a cross-sectional view along line x2-x2 of FIG. 8A.
FIG. 8E is a cross-sectional view along line y2-y2 of FIG. 8A.
FIG. 9A is a plan view that shows the substrate in the method of forming a microstructure according to one embodiment of the present invention.
FIG. 9B is a cross-sectional view along line x1-x1 of FIG. 9A.
FIG. 9C is a cross-sectional view along line y1-y1 of FIG. 9A.
FIG. 9D is a close-up view of region ζ of FIG. 9B.
FIG. 9E is a close-up view of region η of FIG. 9C.
FIG. 10A is a cross-sectional view along line x2-x2 of FIG. 9A that shows the substrate in the method of forming a microstructure according to one embodiment of the present invention.
FIG. 10B is a close-up view of FIG. 10A.
FIG. 10C is a cross-sectional view along line y2-y2 of FIG. 9A.
FIG. 10D is a close-up view of FIG. 10C.
FIG. 11A is a plan view that shows the substrate in the method of forming a microstructure according to one embodiment of the present invention.
FIG. 11B is a cross-sectional view along line x-x of FIG. 11A.
FIG. 11C is a cross-sectional view along line y-y of FIG. 11A.
FIG. 12A is a plan view that shows the substrate manufactured by the method of forming a microstructure according to one embodiment of the present invention.
FIG. 12B is a cross-sectional view along line x-x of FIG. 12A.
FIG. 12C is a cross-sectional view along line y-y of FIG. 12A.
FIG. 13 is an outline configuration drawing of the laser irradiation device according to one embodiment of the present invention.
FIG. 14 is a flowchart that shows the method of manufacturing an interconnection substrate using the laser irradiation device according to one embodiment of the present invention.
FIG. 15A is a plan view that shows the substrate in the method of forming a microstructure according to one embodiment of the present invention.
FIG. 15B is a cross-sectional view along line x-x of FIG. 15A.
FIG. 15C is a cross-sectional view along line y1-y1 of FIG. 15A.
FIG. 15D is a cross-sectional view along line y2-y2 of FIG. 15A.
FIG. 16A is a plan view that shows the substrate in the method of forming a microstructure according to one embodiment of the present invention.
FIG. 16B is a cross-sectional view along line x-x of FIG. 16A.
FIG. 16C is a cross-sectional view along line y1-y1 of FIG. 16A.
FIG. 16D is a cross-sectional view along line y2-y2 of FIG. 16A.
FIG. 17A is a close-up view of region F1 of FIG. 16C.
FIG. 17B is a close-up view of region F2 of FIG. 16D.
FIG. 18 is a plan view of a substrate that describes the method of forming a microstructure according to one embodiment of the present invention.
FIG. 19A is a plan view that shows a substrate in the method of forming a microstructure according to one embodiment of the present invention.
FIG. 19B is a cross-sectional view along line y1-y1 of FIG. 19A.
FIG. 19C is a cross-sectional view along line y2-y2 of FIG. 19A.
FIG. 20 is a plan view that shows a substrate in the method of forming a microstructure according to one embodiment of the present invention.
FIG. 21 is a cross-sectional view along line y1-y1 and line y2-y2 of FIG. 20 that shows a substrate in the method of forming a microstructure according to one embodiment of the present invention.
FIG. 22A is a plan view that shows a substrate in the method of forming a microstructure according to one embodiment of the present invention.
FIG. 22B is a cross-sectional view along line y1-y1 of FIG. 22A.
FIG. 22C is a cross-sectional view along line y2-y2 of FIG. 22A.
FIG. 23A is a perspective view that shows a cross section along line x-x of FIG. 22A.
FIG. 23B is a cross-sectional view along line x-x of FIG. 22A.
FIG. 24A is a plan view that shows a substrate in which is formed a micro hole that is a microstructure according to one embodiment of the present invention.
FIG. 24B is a cross-sectional view along line x-x of FIG. 24A.
FIG. 24C is a cross-sectional view along line y-y of FIG. 24A.

### EMBODIMENTS FOR CARRYING OUT THE INVENTION

Hereinbelow, preferred embodiments of the present invention shall be described with reference to the drawings.
Note that hereinbelow, a description is given mentioning as an example the case of forming a microstructure in a substrate and using this microstructure as through-hole interconnections or fluidic channels, however the use of microstructures formed in a substrate in the present invention is not limited thereto.

### <First Embodiment: Interposer Substrate 10>

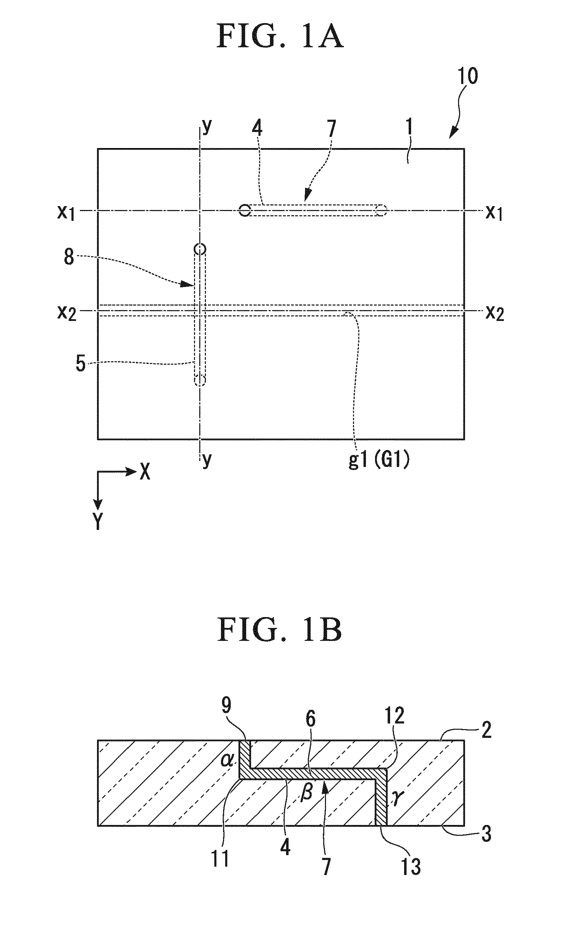

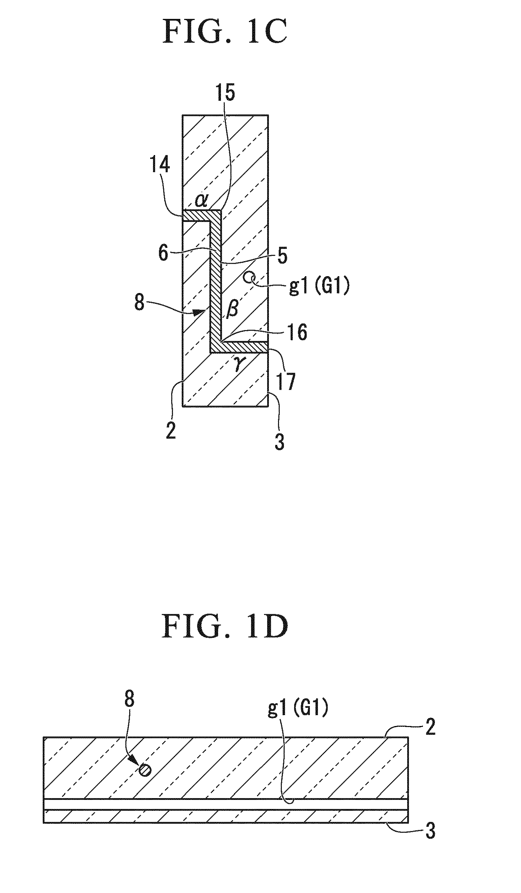

FIG. 1A is a plan view of the interposer substrate 10 according to the first embodiment of the present invention. FIG. 1B is a cross-sectional view along line x1-x1 of FIG. 1A. FIG. 1C is a cross-sectional view along line y-y of FIG. 1A. FIG. 1D is a cross-sectional view along line x2-x2 of FIG. 1A.
This interposer substrate 10 is provided with a first through-hole interconnection 7 and a second through-hole interconnection 8 that are formed by arranging a first micro hole 4 and a second micro hole 5 so as to connect one principal surface 2 (first principal surface) and another principal surface 3 (second principal surface) that constitute a substrate 1 and filling or forming a conductive substance 6 in each micro hole.

The first through-hole interconnection 7 is provided with a region α that extends in the thickness direction of the substrate 1 from an opening portion 9 that appears at the one principal surface 2 to a bend portion 11, a region β that extends in the lateral direction (X direction) of the substrate 1 to be parallel with the principal surfaces of the substrate 1 from the bend portion 11 to a bend portion 12, and a region γ that extends in the thickness direction of the substrate 1 from the bend portion 12 to an opening portion 13 that is exposed at the other principal surface 3.

A region α, a region β, and a region γ of the first micro hole 4 correspond to the region α, the region β, and the region γ of the first through-hole interconnection 7.
In the regions α to γ of the first micro hole 4, a portion in which an uneven profile with a banded shape (stria mark) is formed on the inner wall surface of that micro hole is included (not illustrated). This banded uneven profile is an unevenness that is formed in a stria shape (linear shape) nearly parallel with the extension direction of the first micro hole 4. When this banded uneven profile is formed in the first micro hole 4, the adhesion between the conductive substance that is filled or formed in the micro hole and the substrate improves, and when forming the first through-hole interconnection 7 by filling or forming the conductive substance 6, the smooth flowing in of the conductive substance 6 in the first micro hole 4 is facilitated, and so is preferred.

The second through-hole interconnection 8 is provided with a region α that extends in the thickness direction of the substrate 1 from an opening portion 14 that appears at the one principal surface 2 to a bend portion 15, a region β that extends in the vertical direction (Y direction) of the substrate 1 to be parallel with the principal surfaces of the substrate 1 from the bend portion 15 to a bend portion 16, and a region γ that extends in the thickness direction of the substrate 1 from the bend portion 16 to an opening portion 17 that appears at the other principal surface 3.

A region α, a region β, and a region γ of the second micro hole 5 correspond to the region α, the region β, and the region γ of the second through-hole interconnection 8.
In the regions α to γ of the second micro hole 5, a portion in which an uneven profile with a banded shape (stria mark) is formed on the inner wall surface of that micro hole is included (not illustrated). This banded uneven profile is an unevenness that is formed in a stria shape (linear shape) nearly parallel with the extension direction of the second micro hole 5. When this banded uneven profile is formed along the extension direction of the second micro hole 5, the adhesion between the conductive substance that is filled or formed in the micro hole and the substrate improves, and when forming the second through-hole interconnection 8 by filling or forming the conductive substance 6, the smooth flowing in of the conductive substance 6 in the second micro hole 5 is facilitated, and so is preferred.

It is preferable for the interior of the interconnection substrate of the present embodiment to have a fluidic channel for circulating a fluid consisting of a microstructure (micro hole). Examples of fluids that circulate in this channel include water (H₂O) and air. These fluids may function as a refrigerant that cools the substrate. In addition to this, this microstructure is also applicable to a fluidic channel that circulates biopolymer solutions, such as DNA (nucleic acid), protein materials, and lipids.
By providing a fluidic channel, even if electrodes of a device connected to the interconnection substrate are arranged at a high density, it becomes possible to effectively reduce the temperature rise in the vicinity of this interconnection substrate. In order to further enhance the effect of abatement of this temperature rise, it is preferable for this fluidic channel to be arranged in the direction along both principal surfaces of the substrate.
Furthermore, a banded uneven profile is formed on at least a portion of the inner wall surface of the micro hole (microstructure) that constitutes this fluidic channel. For this reason, in the case of this banded uneven profile being formed along the extension direction of the fluidic channel, a fluid that flows along the fluidic channel flows easily along this banded uneven profile, and so this fluid can circulate through the fluidic channel smoothly.

In the interposer substrate 10 according to the present embodiment, a fluidic channel G1 that consists of a third micro hole g1 is provided extended along the lateral direction (X direction) of the substrate 1, along both principal surfaces of the substrate 1 (refer to FIG. 1A to FIG. 1D). The third micro hole g1 has openings for the entry and exit of a fluid on the two opposing side faces of the substrate 1.

### <Second Embodiment: Surface Interconnection Substrate 30>

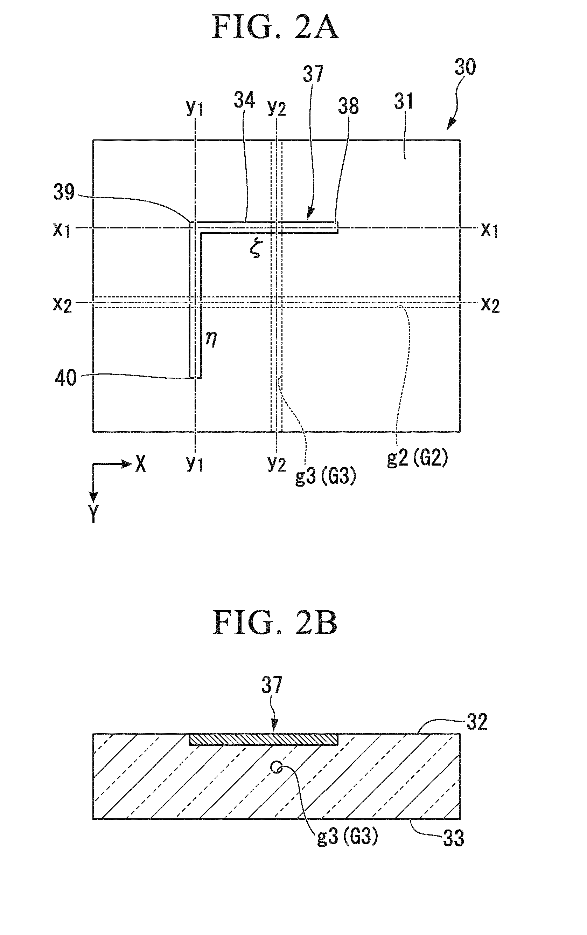

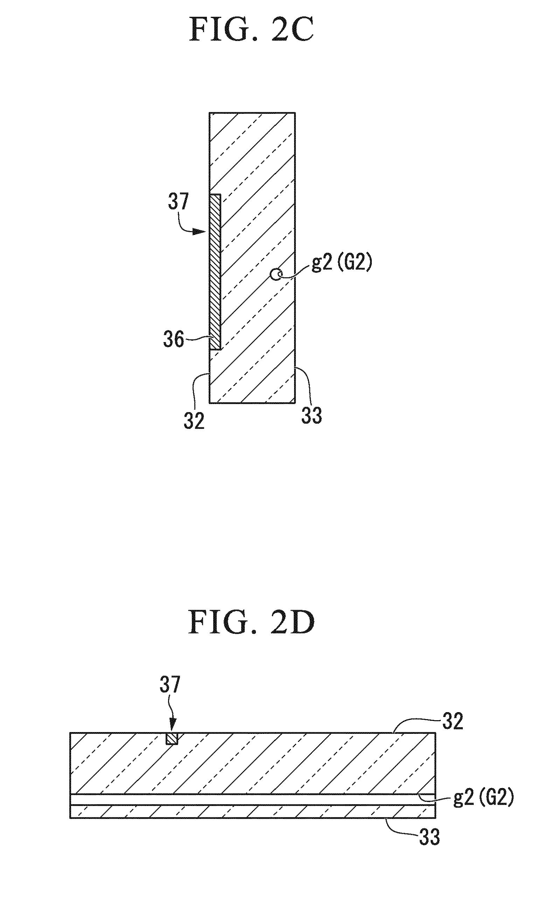

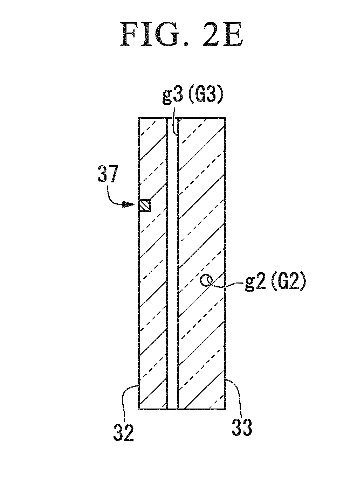

FIG. 2A is a plan view of a surface interconnection substrate 30 according to the second embodiment of the present invention. FIG. 2B is a cross-sectional view along line x1-x1 of FIG. 2A. FIG. 2C is a cross-sectional view along line y1-y1 of FIG. 2A. FIG. 2D is a cross-sectional view along line x2-x2 of FIG. 2A. FIG. 2E is a cross-sectional view along line y2-y2 of FIG. 2A.
This surface interconnection substrate 30 is provided with a first surface interconnection 37 that is formed by a first micro groove 34 being formed in the surface of one principal surface 32 (first principal surface) that constitutes a substrate 31, and filling or forming a conductive substance 36 in this micro groove 34. Moreover, a first fluidic channel G2 that consists of a first micro hole g2, and a second fluidic channel G3 that consists of a second micro hole g3 are provided in the surface interconnection substrate 30.

The first surface interconnection 37 consists of a region ζ that extends in the lateral direction (X direction) of the substrate 31 from one end portion 38 (first end portion) to the bend portion 39, and a region η that extends in the vertical direction (Y direction) of the substrate 31 from the bend portion 39 to the other end portion 40 (second end portion).
The region ζ and the region η, together with the one end portion 38 and the other end portion 39 of the first micro groove 34 correspond to the region ζ and the region η, together with the one end portion 38, the bend portion 39, and the other end portion 40 of the first surface interconnection 37.

In the region ζ and the region η of the first micro groove 34, a portion in which a banded uneven profile (stria mark) is formed on the inner wall surface of the micro groove is included (not illustrated). This banded uneven profile is an unevenness that is formed in a stria shape (linear shape) nearly parallel with the extension direction of the first micro groove 34.

In the surface interconnection substrate 30 of the present embodiment, the first fluidic channel G2 that consists of a first micro hole g2 is provided in an extended manner in the lateral direction (the X direction) of the substrate 1 along both principal surfaces of the substrate 1 (refer to FIG. 2A to FIG. 2E). The first micro hole g2 has openings for the entry and exit of fluid on the two opposing side faces of the substrate 1.

In the surface interconnection substrate 30 of the present embodiment, the second fluidic channel G3 that consists of a second micro hole g3 is provided in an extended manner in the vertical direction (the Y direction) of the substrate 1 along both principal surfaces of the substrate 1 (refer to FIG. 2A to FIG. 2E). The second micro hole g3 has openings for the entry and exit of fluid on the two opposing side faces of the substrate 1.

The material of the substrates 1 and 31 in the interposer substrate 10 and the surface interconnection substrate 30 includes insulators such as glass and sapphire, and semiconductors such as silicon (Si). In these materials, the coefficient-of-linear-expansion difference with a semiconductor device is small. For this reason, when connecting the interposer substrate 10 and the surface interconnection substrate 30, and a semiconductor device using solder or the like, high-precision connection is possible without positional shifting occurring. Moreover, among these materials, a glass that has insulating properties is preferred. In the case of the substrate material being glass, there is no need to form an insulating layer on the inner wall surface of the micro hole and micro groove. For this reason, there is the advantage of a high-speed transmission obstruction factor due to the existence of a stray capacitance component or the like not being present.

The thickness of the substrates 1 and 31 (the distance from the one principal surface 2 and 32 (first principal surface) to the other principal surface 3 and 33 (second principal surface)) can be suitably set, and for example includes a range of approximately 150 µm to 1 mm.
Examples of the conductive substance 6 and 36 that is filled or formed in each micro hole 7 and 8 and the first micro groove 37 arranged in the interposer substrate 10 and the surface interconnection substrate 30, respectively, include for example gold-tin (Au-Sn), and copper (Cu).

The shape of the microstructure, and the patterns and cross-sectional shapes of the through-hole interconnection, surface interconnection and fluidic channel provided in the interconnection substrate according to the present embodiment are not limited to the above examples, and may be suitably designed.

### <Method of Manufacturing Through-hole Interconnection Substrate 10>

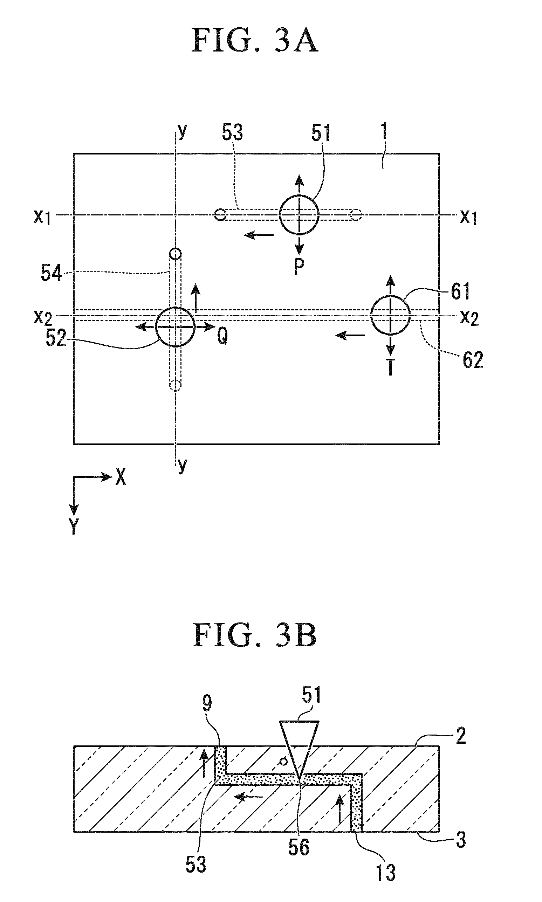

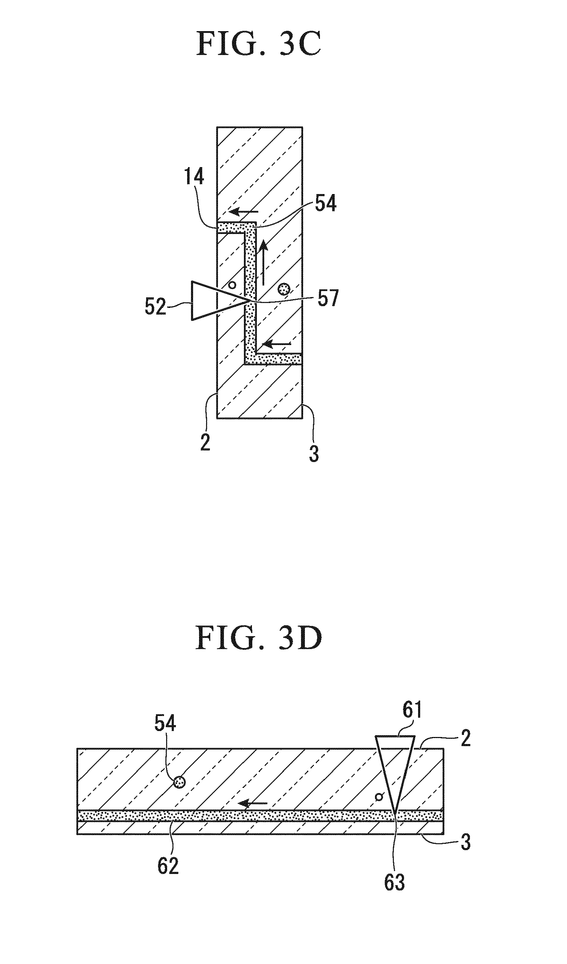

Next, the method of manufacturing the through-hole interconnection substrate 10 is shown in FIG. 3A to FIG. 7D, as a method of forming a micro hole in the interconnection substrate according to one embodiment of the present invention.
Here, FIG. 3A to FIG. 7D are plan views and cross-sectional views of the substrate 1 for manufacturing the through-hole interconnection substrate 10. FIG. 3A is a plan view that shows the substrate in the method of forming a microstructure according to one embodiment of the present invention. FIG. 3B is a cross-sectional view along line x1-x1 of FIG. 3A. FIG. 3C is a cross-sectional view along line y-y of FIG. 3A. FIG. 3D is a cross-sectional view along line x2-x2 of FIG. 3A.

### [Step A]

First, as shown in FIG. 3A to FIG. 3D, a first laser beam 51, a second laser beam 52, and a third laser beam 61 are irradiated on the substrate 1, whereby a first modified region 53, a second modified region 54, and a third modified region 62 in which the material of the substrate 1 is modified are formed in the substrate 1. Each modified region is formed in a region where the first through-hole interconnection 7, the second through-hole interconnection 8, and the fluidic channel G1 are to be respectively provided.

Examples of the material of the substrate 1 include insulators such as glass and sapphire, and semiconductors such as silicon (Si). In these materials, the coefficient-of-linear-expansion difference with a semiconductor device is small. For that reason, when connecting the interposer substrate 10 and a semiconductor device using solder or the like, high-precision connection is possible without positional shifting occurring. Moreover, among these materials, a glass that has insulating properties is preferred. In the case of the substrate material being glass, there is no need to form an insulating layer on the inner wall surface of the micro hole. For this reason, there are such advantages of there being no factor obstructing high-speed transmission due to the existence of a stray capacitance component.
The thickness of the substrate 1 can be suitably set, and for example may be set to a range of approximately 150 µm to 1 mm.

The first laser beam 51, the second laser beam 52, and the third laser beam 61 are irradiated on the substrate 1 from the one principal surface 2 side of the substrate 1, and a first focal point 56, a second focal point 57 and a third focal point 63 are converged at predetermined positions within the substrate 1. The material of the substrate 1 is modified at the positions where the focal points 56, 57 and 63 are converged.
Accordingly, while irradiating the first laser beam 51, the second laser beam 52, and the third laser beam 61 on the substrate 1, the respective positions of the first focal point 56, the second focal point 57, and the third focal point 63 are successively shifted and scanned (moved). In this way, by converging the focal points 56, 57, and 63 over the entirety of the regions where the first micro hole 4, the second micro hole 5, and the third micro hole g1 are respectively provided, it is possible to form the first modified region 53, the second modified region 54, and the third modified region 62.

Each of the laser beams 51, 52, 61 may be irradiated on the substrate 1 from the one principal surface 2 and/or the other principal surface 3 side of the substrate 1, and may be irradiated on the substrate 1 from a side face of the substrate 1. The angle at which the optical axis of the laser beams 51 and 52 is incident on the substrate 1 is set to a predetermined angle. The laser beams 51, 52, and 61 may be irradiated in sequence using a single laser beam, or may be simultaneously irradiated using a plurality of laser beams.

Also, an example of the direction of scanning the laser beams 51 and 52 is a single-stroke direction in the manner of the solid-line arrow along each modified region 53 and 54 shown in FIG. 3A to FIG. 3D (the direction along the line traced in a single action). That is to say, each arrow respectively expresses scanning the focal point 56 and 57 from the section that becomes the opening portion 13 and 17 of the other principal surface 3 of the substrate 1 to the section that becomes the opening portion 9, 14 of the one principal surface 2. At this time, scanning in a single stroke in the direction of the arrow (scanning that is performed in a single action) is preferred in terms of manufacturing efficiency.

An example of the direction of scanning the third laser beam 61 is a single-stroke direction in the manner of the solid-line arrow along the third modified region 62 shown in FIG. 3A to FIG. 3D (the direction along the line traced in a single action). That is to say, the arrow expresses the scanning of the third focal point 63 from the section that becomes the opening portion on one side face to the section that becomes the opening portion on the other side face, among the two opposing side faces of the substrate 1. At this time, scanning in a single stroke in the direction of the arrow (scanning that is performed in a single action) is preferred in terms of manufacturing efficiency.

This first laser beam 51 is a laser beam that is linearly polarized. The orientation P of this linear polarization is always maintained perpendicular to the scanning direction of the focal point 56 of the first laser beam 51 during irradiation of the laser light.
That is to say, the orientation P of this linear polarization of the first laser beam 51 is always perpendicular to the direction of extension of the first modified region 53 (X direction or substrate thickness direction). In FIG. 3A, the orientation P of the linear polarization of the first laser beam 51 is shown by both arrows of the solid line. In FIG. 3B, the orientation P of this linear polarization is shown by a circle that expresses the proximal and depth directions on the page.

The second laser beam 52 is a laser beam that is linearly polarized. The orientation Q of this linear polarization is always maintained perpendicular to the scanning direction of the focal point 57 of the second laser beam 52 during irradiation of laser beam.
That is to say, the orientation Q of this linear polarization of the second laser beam 52 is always perpendicular to the direction of extension of the second modified region 54 (Y direction or substrate thickness direction). In FIG. 3A, the orientation Q of the linear polarization of the second laser beam 52 is shown by both arrows of the solid line. In FIG. 3C, the orientation Q of this linear polarization is shown by a circle that expresses the proximal and depth directions on the page.

The third laser beam 61 is a laser beam that is linearly polarized. The orientation T of this linear polarization is always maintained perpendicular to the scanning direction of the focal point 63 of the third laser beam 61 during irradiation of laser beam.
That is to say, the orientation T of this linear polarization of the third laser beam 61 is always perpendicular to the direction of extension of the third modified region 62 (X direction). In FIG. 3A, the orientation T of the linear polarization of the third laser beam 61 is shown by both arrows of the solid line. In FIG. 3D, the orientation T of this linear polarization is shown by a circle that expresses the proximal and depth directions on the page.

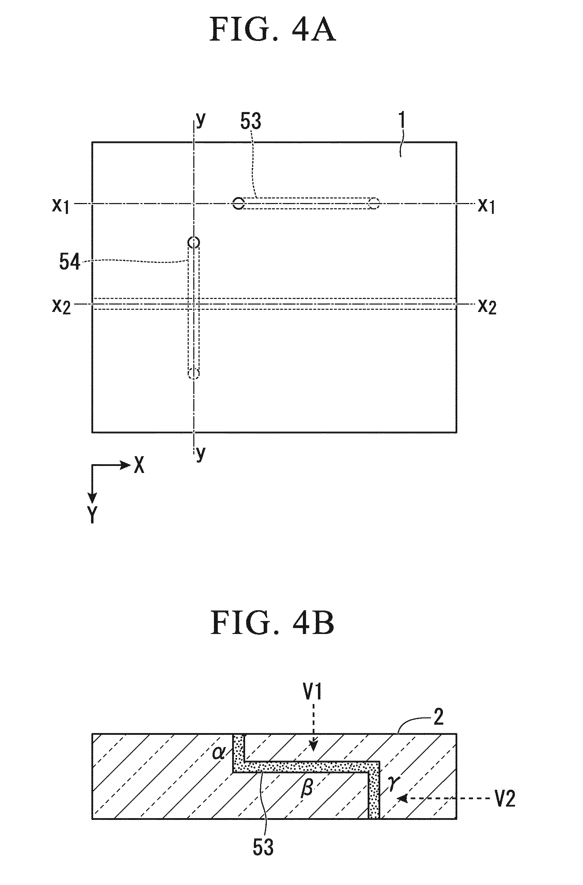

In this way, by controlling the orientations P, Q of the linear polarization of the first laser beam 51 and the second laser beam 52, in the first modified region 53 and the second modified region 54 to be formed, easy to etch areas (fast etching speed) areas 53s, 54s and hard to etch (slow etching speed) areas 53h, 54h are formed parallel to the respective extension directions of the first modified region 53 and the second modified region 54 and side-by-side in an alternating manner (refer to FIG. 4A to FIG. 4E).
Note that the number of each area shown in FIG. 4A to FIG. 4E is not limited to a particular number. This number can be changed by controlling the conditions of use of the laser beams that are used and the extent of linear polarization.

As shown in FIG. 4B, in the first modified region 53, the fast etching speed area 53s and the slow etching speed area 53h extend in the thickness direction of the substrate 1 in the region α of the first modified region 53, extend in the lateral direction (X direction) of the substrate 1 in the region β of the first modified region 53, and extend in the thickness direction of the substrate 1 in the region γ of the first modified region 53.

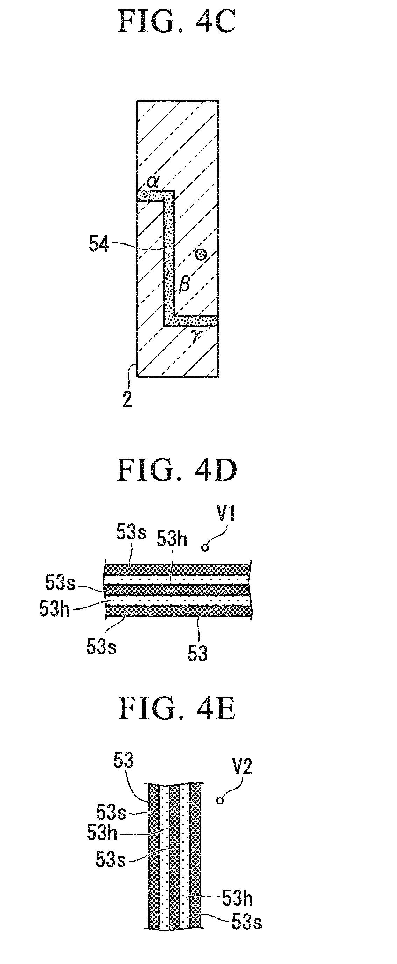

When viewing the region β in the direction of the arrow V1 from the one principal surface 2 side of the substrate 1, the fast etching speed area 53s and the slow etching speed area 53h are arranged side-by-side in parallel with the extension direction of the first modified region 53 (refer to FIG. 4D). In FIG. 4D, two of the slow etching speed areas 53h are arranged in parallel sandwiched between three of the fast etching speed areas 53s.

When viewing the region γ in the direction of the arrow V2 from the side surface side of the substrate 1, the fast etching speed area 53s and the slow etching speed area 53h are arranged side-by-side in parallel with the extension direction of the first modified region 53 (refer to FIG. 4E). In FIG. 4E, two of the slow etching speed areas 53h are arranged mutually in parallel sandwiched between three of the fast etching speed areas 53s.

Also, in the second modified region 54 as well, similarly to the aforementioned first modified region 53, the fast etching speed area and the slow etching speed area extend in the thickness direction of the substrate 1 in the region α of the second modified region 54, extend in the vertical direction (Y direction) of the substrate 1 in the region β of the second modified region 54, and extend in the thickness direction of the substrate 1 in the region γ of the second modified region 54 (refer to FIG. 4C).

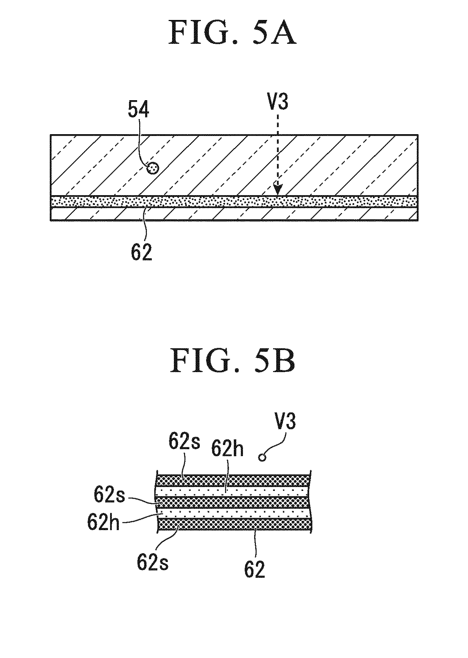

By controlling the orientation T of the linear polarization of the third laser beam 61, in the third modified region 62 to be formed, easy to etch areas (fast etching speed) areas 62s and hard to etch (slow etching speed) areas 62h are formed parallel to the extension direction of the third modified region 62 and side-by-side in an alternating manner (refer to FIG. 5A to FIG. 5B).
Here, the number of each area shown in FIG. 5A and FIG. 5B is not limited to a particular number. This number can be changed by controlling the conditions of use of the laser beams that are used and the extent of linear polarization. Note that FIG. 5A is a cross-sectional view along line x2-x2 in the plan view of FIG. 4A. FIG. 5B is a drawing viewed from the one principal surface 2 side of the substrate 1 in the direction of the arrow V3.

In this way, by performing laser scanning while maintaining the orientations P, Q, T of the linear polarization of the irradiation lasers to be perpendicular to the extension directions of the modified regions 53, 54, and 62, in all of the regions of the modified regions 53, 54, and 62 that are formed, areas with differing etching speeds that run side-by-side in a parallel manner with respect to the extension direction are alternately formed.
As a result, in a subsequent etching step (Step B), it is possible to make constant the etching speed of all regions of the modified regions 53, 54, and 62. Thereby, it is possible to control the diameter (thickness) of the micro holes 4, 5 that are formed to have no variation. In the present embodiment, the sizes of the modified regions 53, 54, 62 are controlled so as to be 4 µm.

Note that the focal points 56, 57, 63 of the respective laser beams 51, 52, 61 may be scanned, with the orientations P, Q, T of the linear polarization of the aforementioned irradiation laser beams changed to be kept parallel with respect to the extension direction of the modified regions 53, 54, and 62. In this case, in all regions of the modified regions 53, 54, 62 that are formed, fast etching speed areas and slow etching speed areas are alternately formed perpendicularly to the extension direction thereof. In this case, in the subsequent etching step (Step B), it is possible to make constant the etching speed of all regions of the modified regions 53, 54, 62.

Moreover, the focal points 56, 57, 63 of the respective laser beams 51, 52, 61 may be scanned while keeping the orientations P, Q, T of the linear polarization of the aforementioned irradiation laser beams to be always fixed in arbitrary directions not limited to perpendicular or parallel with respect to the extension directions of the modified regions 53, 54, 62. In this case, in all regions of the modified regions 53, 54, 62 that are formed, fast etching speed areas and slow etching speed areas are alternately formed in directions perpendicular to the orientations of the linear polarizations P, Q, T thereof. In this case as well, in the subsequent etching step (Step B), it is possible to make constant the etching speed of all regions of the modified regions 53, 54, 62.

The directions of the orientations P, Q, T of the linear polarization of the aforementioned irradiation laser beams with respect to the extension directions of the modified regions 53, 54, 62 influence the etching speed in the subsequent etching step (Step B). From the aspect of increasing the etching speed per unit length of the modified region, it is preferable to carry out laser irradiation while keeping the orientations P, Q, T of the linear polarization of the irradiation laser beams perpendicular with respect to the extension directions of the modified regions 53, 54, 62. The etching speed per unit length of the modified regions that are formed keeping the orientations P, Q, T of this linear polarization perpendicular with respect to the extension directions is approximately twice the etching speed per unit length of the modified regions that are formed by keeping the orientations P, Q, T of this linear polarization parallel with respect to the extension directions.

Examples of the light source of the irradiating laser beams 51, 52, 61 include a femptosecond laser. By performing irradiation while controlling the linear polarization of the laser beams 51, 52, and 61 as mentioned above, it is possible to form the modified regions 53, 54, 62 with diameters of several µm to several tens of µm. Moreover, the modified regions 53, 54, and 62 having the desired shape can be formed by controlling the locations at which the focal points 56, 57, and 63 of the laser beams 51, 52, and 61 are focused in the substrate 1.

### [Step B]

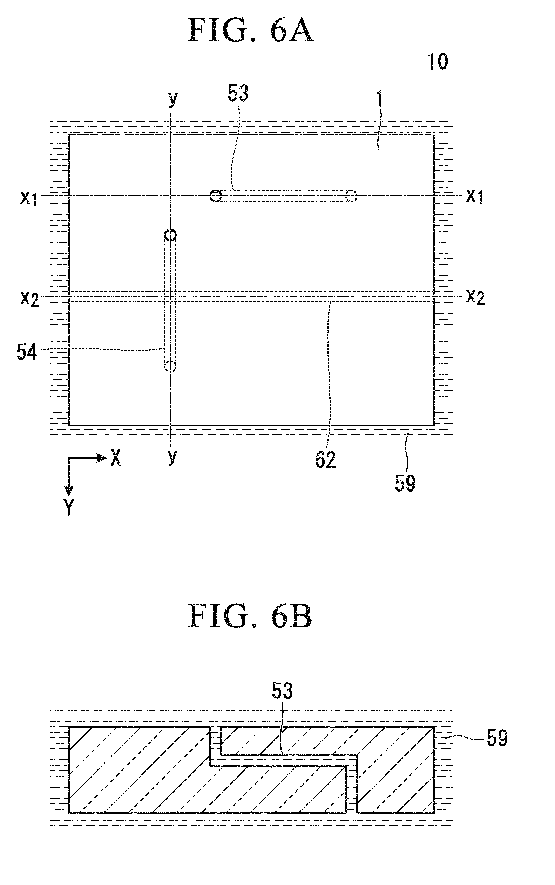

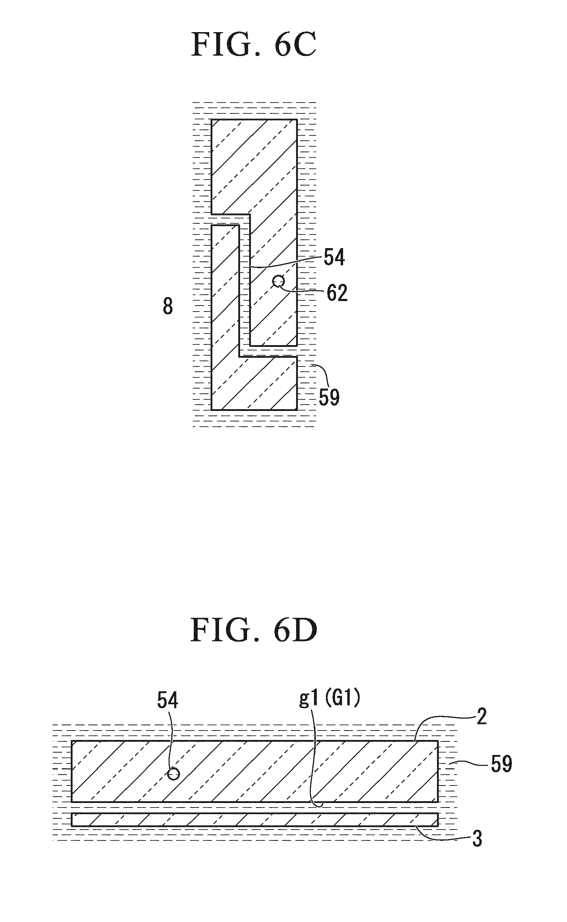

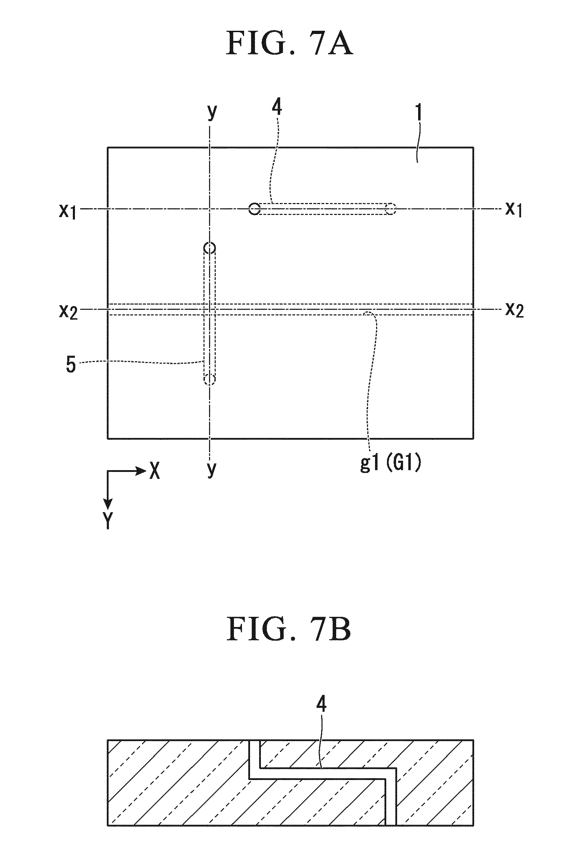

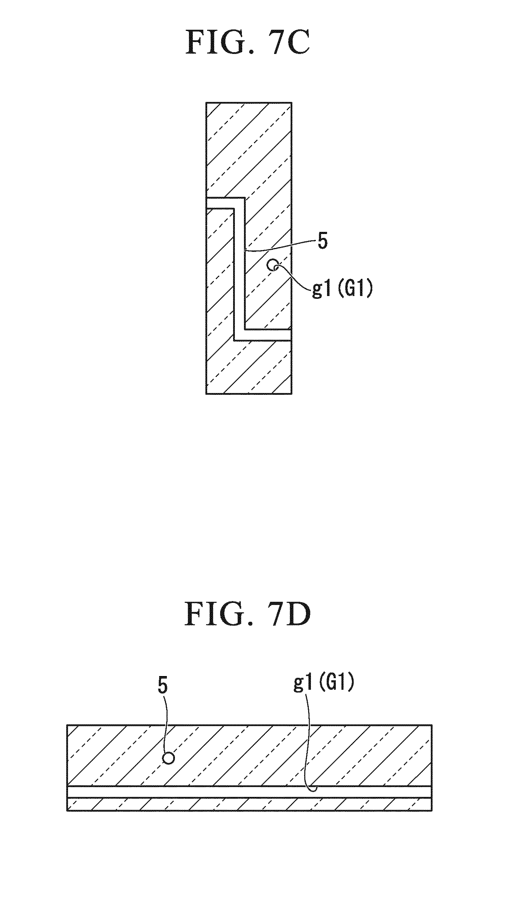

As shown in FIG. 6A to FIG. 6D, by immersing the substrate 1 in which is formed the first modified region 53, the second modified region 54, and the third modified region 62 in an etching liquid (chemical solution) 59 and performing wet etching, the modified regions 53, 54, 62 are removed from the substrate 1. As a result, the first micro hole 4, the second micro hole 5, and the third micro hole g1 are formed in the regions where the first modified region 53, the second modified region 54, and the third modified region 62 existed (refer to FIG. 7A to FIG. 7D). In the present embodiment, glass is used as the material of the substrate 1, and a solution containing 10% by mass of hydrofluoric acid (HF) as the main component is used as the etching solution 59.

This etching employs the phenomenon in which, compared to the portions of the substrate 1 that are not modified, etching is extremely fast at the first modified region 53, the second modified region 54, and the third modified region 62. As a result, it is possible to form the micro holes 4, 5, g1 in accordance with the shapes of the modified regions 53, 54, 62, respectively.
Also, by suitably adjusting the etching time, it is possible to adjust to the desired extent the extent of leaving behind the banded uneven profile that is formed on the inner wall surfaces of the micro holes 4, 5, gl. That is to say, if the etching time is shortened, it is possible to leave behind more of the banded uneven profile. On the other hand, if the etching time is lengthened, it is possible to leave behind only a little of the banded uneven profile or completely remove it.

The etching solution 59 is not particularly limited, and for example it is possible to use a solution having hydrofluoric acid (HF) as a main component, or a nitrohydrofluoric acid series mixed acid in which a suitable amount of nitric acid or the like is added to fluoric acid. Also, it is possible to use another chemical solution in accordance with the material of the substrate 1.

### [Step C]

In the substrate 1 in which the first micro hole 4, the second micro hole 5, and the third micro hole g1 are formed, by filling or forming the conductive substance 6 in the micro holes 4 and 5, the first through-hole interconnection 7 and the second through-hole interconnection 8 are formed, respectively. Examples of this conductive substance 6 include gold-tin (Au-Sn), and copper (Cu). For the filling or forming of this conductive substance 6, it is possible to suitably use a molten metal suction method, plating, or the like.

While filling or forming the conductive substance 6 in the first micro hole 4 and the second micro hole 5, if a suitable lid such as a resist or the like is temporarily applied to the two opening portions of the third micro hole g1 that are opened at the side faces of the substrate 1, the conductive substance 6 may be prevented from being filled or formed in the third micro hole g1. As a result, since the third micro hole gl is maintained as a through hole through which a fluid can pass, it is used as the fluidic channel G1.

The interposer substrate 10 as shown in FIGS. 1A - 1D is obtained by the above steps A to C.
Moreover, in response to a request, land portions may be formed on the opening portions 9, 13, 14, 17 of the through-hole interconnections 7 and 8. It is possible to suitably use a plating method, sputtering method or the like for formation of the land portions.

### <Method of Manufacturing Surface Interconnection Substrate 30>

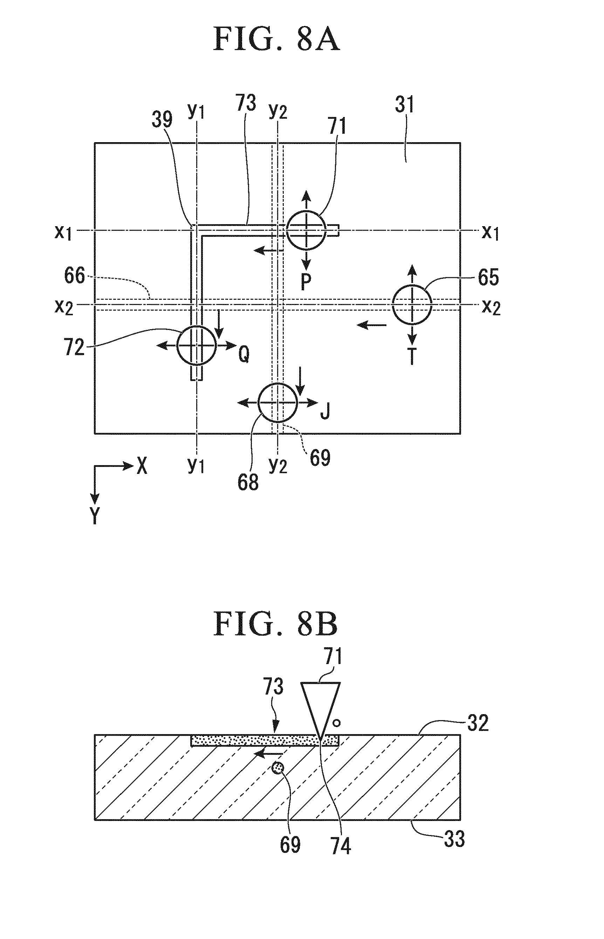

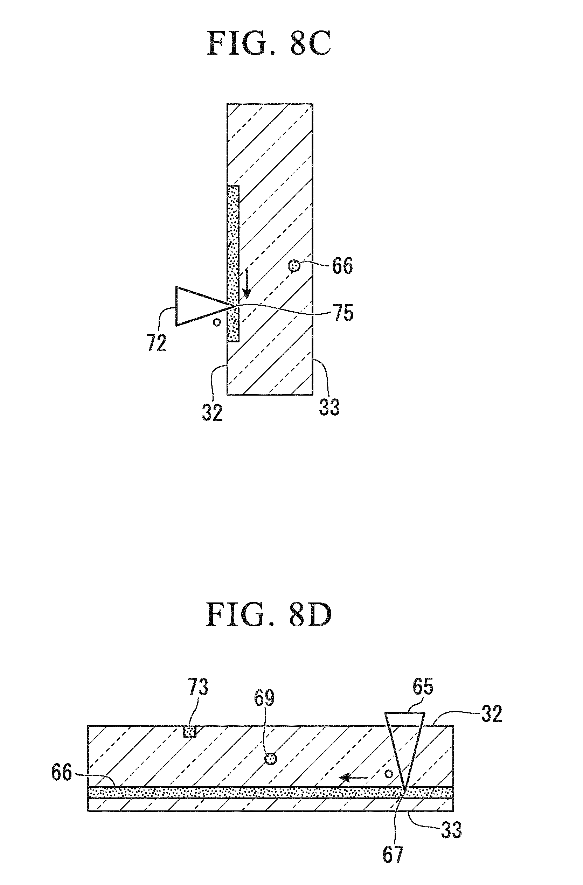

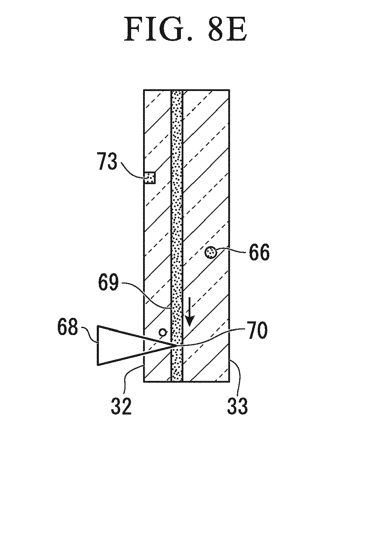

Next, referring to FIG. 8A to FIG. 12C, the method of manufacturing the surface interconnection substrate 30 shall be described as a method of forming micro holes and micro grooves in an interconnection substrate according to another embodiment of the present invention.
Here, FIG. 8A to FIG. 12C are plan views and sectional views of a substrate 31 for manufacturing the surface interconnection substrate 30. FIG. 8A is a plan view that shows the substrate in the method of forming a microstructure according to one embodiment of the present invention. FIG. 8B is a cross-sectional view along line x1-x1 of FIG. 8A. FIG. 8C is a cross-sectional view along line y1-y1 of FIG. 8A. FIG. 8D is a cross-sectional view along line x2-x2 of FIG. 8A. FIG. 8E is a cross-sectional view along line y2-y2 of FIG. 8A.

### [Step A]

First, as shown in FIG. 8A to FIG. 8E, a first laser beam 71, a second laser beam 72, a third laser beam 65, and a fourth laser beam 68 are irradiated on the substrate 31 to form a first modified region 73, a second modified region 66, and a third modified region 69 in which the material of the substrate 31 is modified at portions near the surface of the one principal surface 32 of the substrate 31. The first modified region 73 is formed in the region where the first surface interconnection 37 is provided. The second modified region 66 is formed at the region where the first fluidic channel G2 is provided. And the third modified region 69 is formed in the region where the second fluidic channel G3 is provided.

Examples of the material of the substrate 31 include insulators such as glass and sapphire, and semiconductors such as silicon (Si). In these materials, the coefficient-of-linear-expansion difference with a semiconductor device is small. For this reason, when connecting the surface interconnection substrate 30 and a semiconductor device using solder or the like, high-precision connection is possible without positional shifting occurring. Moreover, among these materials, a glass that has insulating properties is preferred. In the case of the substrate material being glass, there is no need to form an insulating layer on the inner wall surface of the micro hole and micro groove. Therefore, there is the advantage of there being no factor obstructing high-speed transmission due to the existence of a stray capacitance component.
The thickness of the substrate 31 can be suitably set, and for example includes a range of approximately 150 µm to 1 mm.

The first laser beam 71, the second laser beam 72, the third laser beam 65, and the fourth laser beam 68 are irradiated from the one principal surface 2 side of the substrate 31, to form a first focal point 74, a second focal point 75, a third focal point 67, and a fourth focal point 70 at desired positions of the portion near the surface of the substrate 31. The material of the substrate 31 is modified at the positions where the focal points 74, 75, 67, 70 are converged.
Accordingly, while irradiating the laser beams 71, 72, 65, 68, the respective positions of the first focal points 74, 75, 67, 70 are successively shifted and scanned (moved). In this way, by converging the focal points 74, 75, 67 and 70 over the entirety of the regions where the first micro groove 34, the first fluidic channel G2, and the second fluidic channel G3 are provided, it is possible to form the first modified region 73, the second modified region 66, and the third modified region 69.

Each of the laser beams 71, 72, 65, 68 may be irradiated on the substrate 31 from the one principal surface 32 and/or the other principal surface 33 side of the substrate 31, and may be irradiated on the substrate 31 from the side face of the substrate 31. The angle at which the optical axis of the laser beams 71, 72, 65, 68 are incident on the substrate 31 is set to a predetermined angle. The laser beams 71, 72, 65, 68 may be irradiated in sequence using a single laser beam, or may be simultaneously irradiated using a plurality of laser beams.

Also, the direction of scanning the focal points 74 and 75 of the laser beams 71 and 72 includes for example a single-stroke direction in the manner of the solid-line arrow along the first modified region 73 shown in FIG. 8A to FIG. 8D (the direction along the line traced in a single action). That is to say, the arrows express the first laser beam 71 scanning the focal point 74 from a section that becomes one end portion 38 of the first modified region 73 to the section that becomes the bend portion 39, and the second laser beam 72 scanning the focal point 75 from a section that becomes a bend portion of the first modified region 73 to a section that becomes the other end portion 40. At this time, scanning in a single stroke in the direction of the arrow (scanning that is performed in a single action) is preferred in terms of manufacturing efficiency.

Also, the direction of scanning the third laser beam 65 includes for example a single-stroke direction in the manner of the solid-line arrow along the second modified region 66 shown in FIG. 8A to FIG. 8E (the direction along the line traced in a single action). That is to say, the arrow expresses scanning the third focal point 67 from a section that becomes the opening portion on one side face to a section that becomes the opening portion on the other side face, among the two opposing side faces of the substrate 31. At this time, scanning in a single stroke in the direction of the arrow (scanning that is performed in a single action) is preferred in terms of manufacturing efficiency.

The direction of scanning the fourth laser beam 68, for example, includes for example a single-stroke direction in the manner of the solid-line arrow along the third modified region 69 shown in FIG. 8A to FIG. 8E (the direction along the line traced in a single action). That is to say, the arrow expresses scanning the fourth focal point 70 from a section that becomes the opening portion on one side face to a section that becomes the opening portion on the other side face, among the two opposing side faces of the substrate 31. At this time, scanning in a single stroke in the direction of the arrow (scanning that is performed in a single action) is preferred in terms of manufacturing efficiency.

This first laser beam 71 is a laser beam that is linearly polarized. The orientation P of this linear polarization is always maintained perpendicular to the scanning direction of the focal point 74 of the first laser beam 71 during irradiation of the laser beam.
That is to say, the orientation P of this linear polarization of the first laser beam 71 is always perpendicular to the direction of extension of the region ζ of the first modified region 73 (X direction). In FIG. 8A, the orientation P of the linear polarization of the first laser beam 71 is shown by both arrows of the solid line. In FIG. 8B, the orientation P of this linear polarization is shown by a circle that expresses the proximal and depth directions on the page.

This second laser beam 72 is a laser beam that is linearly polarized. The orientation Q of this linear polarization is always maintained perpendicular to the scanning direction of the focal point 75 of the second laser beam 72 during irradiation of the laser beam.
That is to say, the orientation Q of this linear polarization of the second laser beam 72 is always perpendicular to the direction of extension of the region η of the first modified region 73 (Y direction). In FIG. 8A, the orientation Q of the linear polarization of the second laser beam 72 is shown by both arrows of the solid line. In FIG. 8C, the orientation Q of this linear polarization is shown by a circle that expresses the proximal and depth directions on the page.

The third laser beam 65 is a laser beam that is linearly polarized. The orientation T of this linear polarization is always maintained perpendicular to the scanning direction of the focal point 67 of the third laser beam 65 during irradiation of the laser beam.
That is to say, the orientation T of this linear polarization of the third laser beam 65 is always perpendicular to the direction of extension of the third modified region 66 (X direction). In FIG. 8A, the orientation T of the linear polarization of the third laser beam 65 is shown by both arrows of the solid line. In FIG. 8D, the orientation T of this linear polarization is shown by a circle that expresses the proximal and depth directions on the page.

The fourth laser beam 68 is a laser beam that is linearly polarized. The orientation J of this linear polarization is always maintained perpendicular to the scanning direction of the focal point 70 of the fourth laser beam 68 during irradiation of the laser beam.
That is to say, the orientation J of this linear polarization of the fourth laser beam 68 is always perpendicular to the direction of extension of the fourth modified region 69 (Y direction). In FIG. 8A, the orientation J of the linear polarization of the fourth laser beam 68 is shown by both arrows of the solid line. In FIG. 8E, the orientation J of this linear polarization is shown by a circle that expresses the proximal and depth directions on the page.

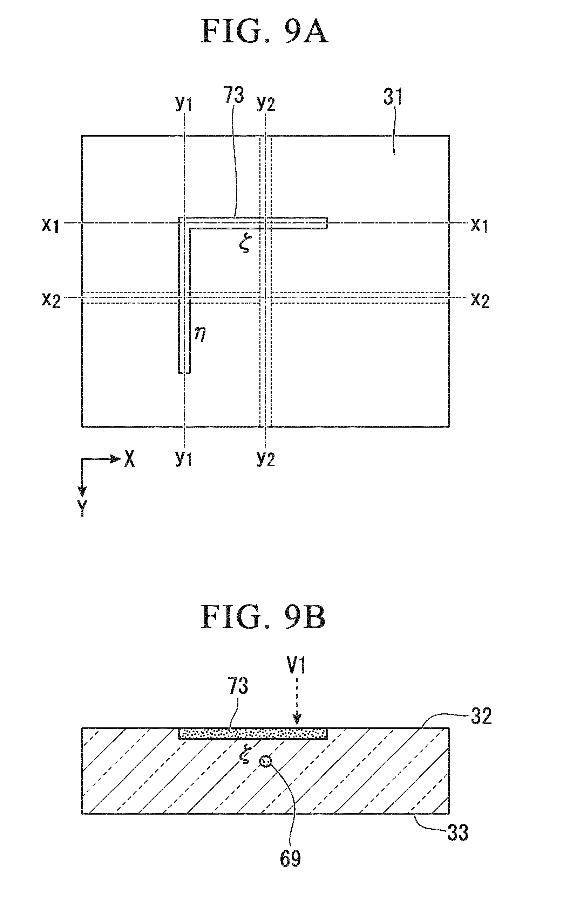

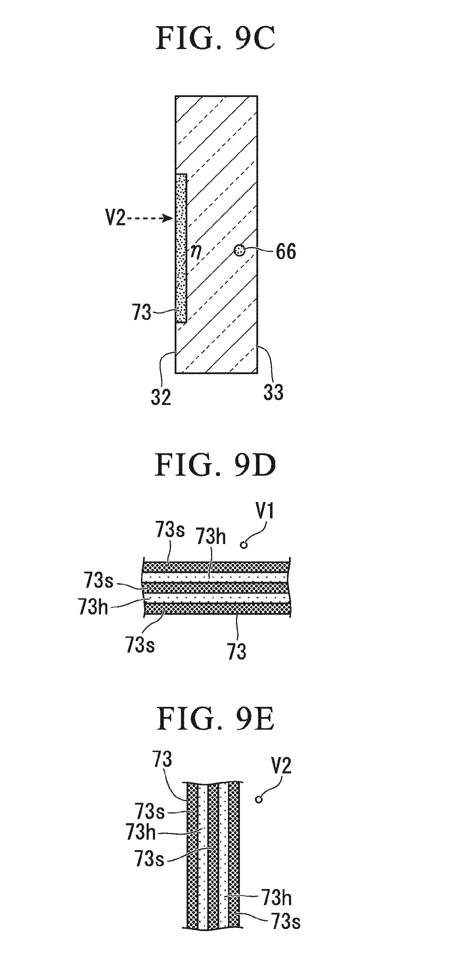

In this way, by controlling the respective orientations P, Q of the linear polarization of the first laser beam 71 and the second laser beam 72, in the first modified region 73 to be formed, easy to etch areas (fast etching speed) areas 73s, and hard to etch (slow etching speed) areas 73h are formed parallel to the respective extension directions of the regions ζ and η of the first modified region 73 and side-by-side in an alternating manner (refer to FIG. 9A to FIG. 9E).
Here, the number of each area shown in FIG. 9A to FIG. 9E is not limited to a particular number. This number can be changed by controlling the conditions of use of the laser beams that are used and the extent of linear polarization.

As shown in FIG. 9A to FIG. 9E, in the first modified region 73, the fast etching speed areas 73s and the slow etching speed areas 73h extend in the horizontal direction (X direction) of the substrate 1 in the region ζ of the first modified region 73, and extend in the vertical direction (Y direction) of the substrate 1 in the region η of the first modified region 73.

When viewing the region ζ in the direction of the arrow V1 from the one principal surface 32 side of the substrate 31, the fast etching speed areas 73s and the slow etching speed areas 73h are arranged side-by-side in parallel with the extension direction of the first modified region 73 (refer to FIG. 9D). In FIG. 9D, two of the slow etching speed areas 73h are arranged in parallel sandwiched between three of the fast etching speed areas 73s.

When viewing the region η in the direction of the arrow V2 from the one principal surface 32 side of the substrate 31, the fast etching speed area 73s and the slow etching speed area 73h are arranged side-by-side in parallel with the extension direction of the first modified region 73 (refer to FIG. 9E). In FIG. 9E, two of the slow etching speed areas 73h are arranged in parallel sandwiched between three of the fast etching speed areas 73s.

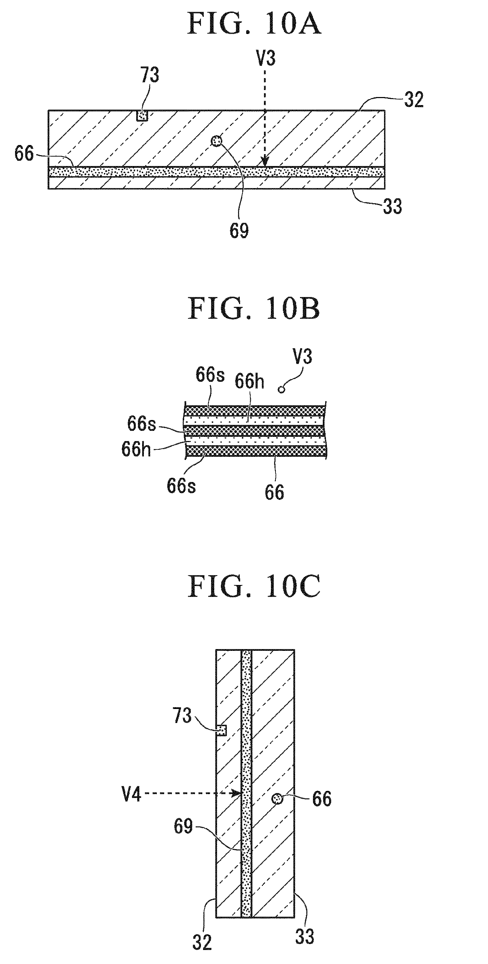

Also, by controlling the orientations T, J of the linear polarization of the third laser beam 65 and the fourth laser beam 68, in the second modified region 66 and the third modified region 69 to be formed, easy to etch areas (fast etching speed) areas 66s, 69s and hard to etch (slow etching speed) areas 66h, 69h are formed parallel to the respective extension directions of the second modified region 66 and the third modified region 69 (X direction, Y direction) and side-by-side in an alternating manner (refer to FIG. 10A to FIG. 10D).
Here, the number of each area shown in FIG. 10A to FIG. 10D is not limited to a particular number. This number can be changed by controlling the conditions of use of the laser beams that are used and the extent of linear polarization.

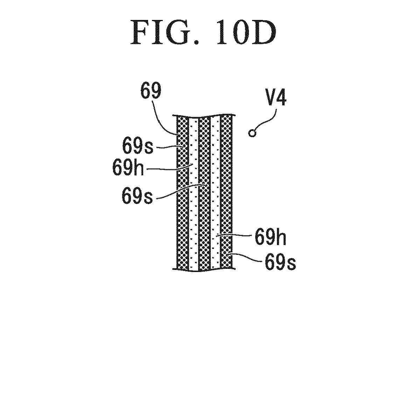

Note that FIG. 10A is a cross-sectional view along line x2-x2 in the plan view of FIG. 9A. FIG. 10B is a view seen in the direction of arrow V3 from the one principal surface 32 side of the substrate 31. FIG. 10C is a cross-sectional view along line y2-y2 in the plan view of FIG. 9A. FIG. 10D is a view seen in the direction of arrow V4 from the one principal surface 32 side of the substrate 31.

In this way, by performing laser irradiation while maintaining the orientations P, Q of the linear polarization of the irradiation laser beams to be perpendicular to the extension directions of the regions ζ and η of the first modified region 73, in all of the regions of the first modified region 73 that are formed, areas with differing etching speeds that run side-by-side in a parallel manner with respect to the extension direction are alternately formed.
As a result, in a subsequent etching step (Step B), it is possible to fix the etching speed of all regions of the first modified region 73. Thereby, it is possible to control the diameter (thickness) of the micro groove 34 to be formed to have no variation in all regions.

Also, by performing laser irradiation while maintaining the orientations T, J of the linear polarization of the irradiation laser beams to be perpendicular to the extension directions of the second modified region 66 and the third modified region 69, in all of the regions of the second modified region 66 and the third modified region 69 that are formed, areas with differing etching speeds that run side-by-side in a parallel manner with respect to the extension direction are alternately formed.
As a result, in the subsequent etching step (Step B), it is possible to fix the etching speed of all regions of the second modified region 66 and the third modified region 69. Thereby, it is possible to control the diameter (size) of the first micro hole g2 and the second micro hole g3 to be formed to have no variation in all areas. Note that in the present embodiment, the size of the second modified region 66 and the third modified region 69 is controlled so as to be 4 µm.

Note that the laser scanning may be performed with the orientations P, Q of the linear polarization of the irradiation laser beams changed to be kept parallel to the extension direction of the first modified region 73. In this case, in all regions of the first modified region 73 that is formed, fast etching speed areas and slow etching speed areas are alternately formed perpendicularly to the extension direction thereof. In this case, in the subsequent etching step (Step B), it is possible to make constant the etching speed of all regions of the modified region 73.

Similarly, note that the laser scanning may be performed with the orientations T, J of the linear polarization of the irradiation laser beams changed to be kept parallel to the respective extension directions of the second modified region 66 and the third modified region 69. In this case, in all regions of the second modified region 66 and the third modified region 69 that are formed, fast etching speed areas and slow etching speed areas are alternately formed perpendicularly to the extension directions thereof. In this case, in the subsequent etching step (Step B), it is possible to make constant the etching speeds of all regions of the modified regions 66, 69.

Moreover, the laser irradiation may be performed while keeping the orientations P, Q of the linear polarization of the aforementioned irradiation laser beams to be always fixed in arbitrary directions not limited to perpendicular or parallel with respect to the extension direction of the first modified region 73. In this case, in all regions of the first modified region 73 that is formed, fast etching speed areas and slow etching speed areas are alternately formed in directions perpendicular to the orientations of the linear polarizations P, Q thereof. In this case as well, in the subsequent etching step (Step B), it is possible to make constant the etching speed of all regions of the first modified region 73.

Similarly, the laser beam may be irradiated while keeping the orientations T, J of the linear polarization of the aforementioned irradiation laser beams to be always fixed in arbitrary directions not limited to perpendicular or parallel with respect to the extension direction of the second modified region 66 and the third modified region 69. In this case, in all regions of the second modified region 66 and the third modified region 69 that are formed, fast etching speed areas and slow etching speed areas are alternately formed in directions perpendicular to the orientations of the linear polarizations J, T thereof. In this case as well, in the subsequent etching step (Step B), it is possible to fix the etching speed of all regions of the modified regions 66 and 69.

Among the orientations P, Q, T, J of the linear polarization of the irradiation lasers described above, the direction with respect the respective extension direction of the modified regions 66 and 69 of the orientation T of the linear polarization of the third laser beam 65 and the orientation J of the linear polarization of the fourth laser beam 68 influence to a greater extent the etching speed in the subsequent etching step (Step B). This is due to the region that is modified by the third laser beam 65 and the fourth laser beam 68 (second modified region 66 and third modified region 69) being a region where the first micro hole g2 and the second micro hole g3 are provided in the substrate 31. From the aspect of increasing the etching speed per unit length of the modified regions 66 and 69, it is preferable to carry out the laser scanning while keeping the orientations T and J of the linear polarization of the irradiation laser beams perpendicular with respect to the extension directions of the modified regions 66 and 69. The etching speed per unit length of the modified regions that are formed by keeping the orientations T, J of the linear polarization perpendicular with respect to the respective extension directions is approximately twice the etching speed per unit length of the modified regions that are formed by keeping the orientations parallel with respect to the extension directions.

Examples of the light source of the irradiation laser beams 71, 72, 65, 68 include a femptosecond laser. By performing irradiation while controlling the linear polarization of the laser beams 71, 72, 65, and 68 as mentioned above, it is possible to form the modified regions 73, 66, 69 with diameters of several µm to several tens of µm. Moreover, the modified region 73 having the desired shape can be formed by controlling the locations of focusing the focal points 74, 75, 67 and 70 of the laser beams 71, 72, 65 and 68 at positions near the surface of the substrate 31.

### [Step B]

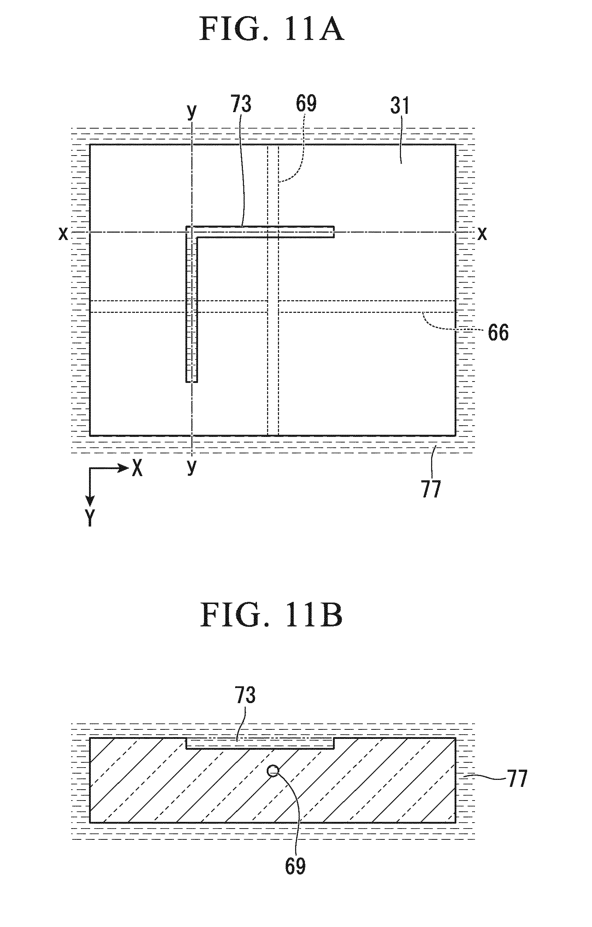

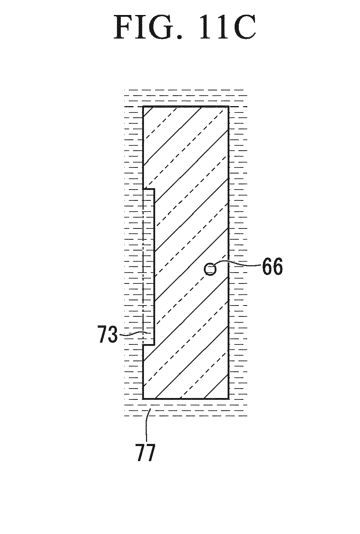

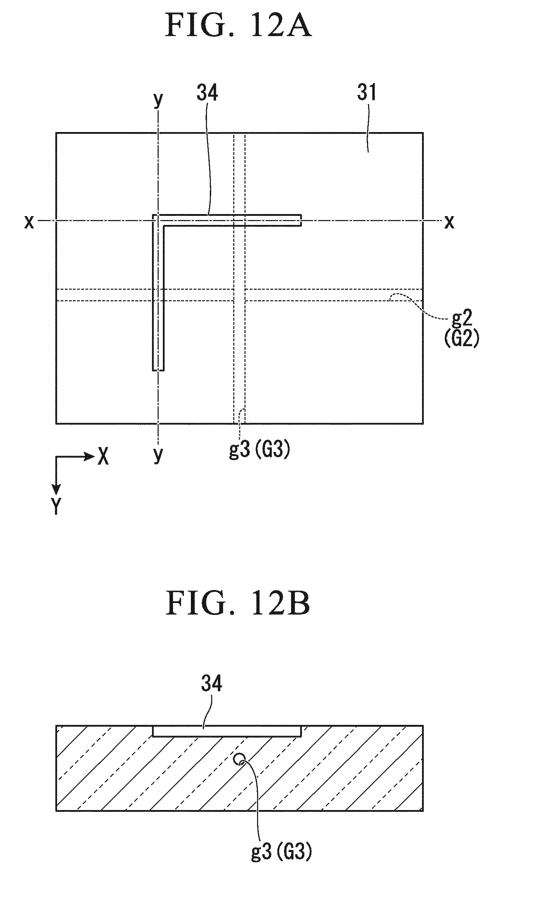

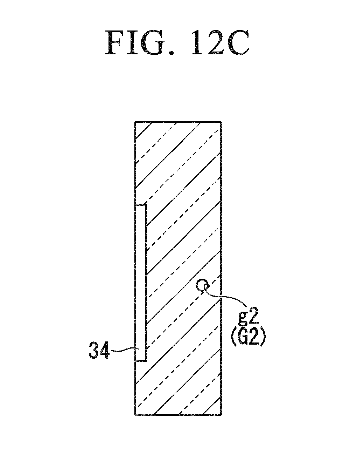

As shown in FIG. 11A to FIG. 11C, by immersing the substrate 31 in which is formed the first modified region 73, the second modified region 66, and the third modified region 69 in an etching liquid (chemical solution) 77 and performing wet etching, the first modified region 73 is removed from the substrate 31. As a result, the first micro groove 34, the first micro hole g2 (G2), and the second micro hole g3 (G3) are formed in the regions where the first modified region 73, the second modified region 66, and the third modified region 69 existed (refer to FIG. 12A to FIG.12C). In the present embodiment, glass is used as the material of the substrate 31, and a solution having hydrofluoric acid (HF) 10% by mass as the main component is used as the etching solution 77.

This etching employs the phenomenon in which, compared to the portions of the substrate 31 that are not modified, etching is extremely fast at the first modified region 73, the second modified region 66, and the third modified region 69. As a result, it is possible to form the first micro groove 34, the first micro hole g2 (G2), and the second micro hole g3 (G3) in accordance with the shapes of the first modified region 73, the second modified region 66, and the third modified region 69.
Also, by suitably adjusting the etching time, it is possible to adjust to the desired extent the extent of leaving behind the banded uneven profile that is formed on the inner wall surfaces of the first micro groove 34, the first micro hole g2 (G2), and the second micro hole g3 (G3). That is to say, if the etching time is shortened, it is possible to leave behind more of the banded uneven profile. On the other hand, if the etching time is lengthened, it is possible to leave behind only a little of the banded uneven profile or completely remove it.

The etching solution 77 is not particularly limited, and for example it is possible to use a solution having hydrofluoric acid (HF) as a main component, or a nitrohydrofluoric acid series mixed acid in which a suitable amount of nitric acid or the like is added to fluoric acid. Also, it is possible to use another chemical solution in accordance with the material of the substrate 31.

### [Step C]

In the substrate 31 in which the first micro groove 34, the first micro hole g2 (G2), and the second micro hole g3 (G3) are formed, filling or forming the conductive substance 36 in the first micro groove 34 forms the first surface interconnection 37. Examples of this conductive substance 36 include gold-tin (Au-Sn), and copper (Cu).

As a method of filling or forming this conductive substance 36, a method can be illustrated that has the following steps. First, a film that consists of the conductive substance 36 is formed over the entire upper surface of the substrate 31 by sputtering, to fill or form the conductive substance 36 in the micro groove 34. Next, after performing masking by forming a resist film on this micro groove 34, dry etching of the upper surface of the substrate 31 is performed to remove a film that consists of the conductive substrate 36. Finally, the resist of the masking is removed.

While filling or forming the conductive substance 36 in the first micro groove 34, if a suitable lid such as a resist or the like is temporarily applied to the total of four opening portions of the first micro hole g2 (G2) and the second micro hole g3 (G3) that are opened at the side faces of the substrate 31, it is possible to prevent the conductive substance 36 from being filled or formed in the micro holes g2 and g3. As a result, since the micro holes g2, g3 are maintained as through holes through which a fluid can pass, they are used as the fluidic channels G2, G3.

The surface interconnection substrate 30 as shown in FIGS. 2A to 2E is obtained by the above steps A to C.
Moreover, in response to a request, land portions may be formed at predetermined positions of the surface interconnection 34 (for example, the one end portion 38 and the other end portion 40). It is possible to suitably use a plating method, sputtering method or the like for formation of the land portions.

### <Laser Irradiation Device>

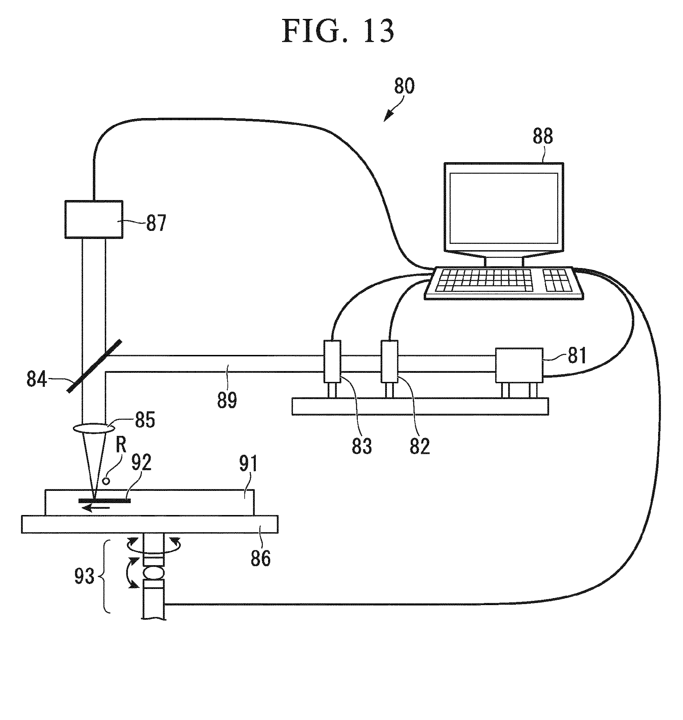

Next, a laser irradiation device 80 shall be described as the laser irradiation device that can be used for the method of forming a microstructure in an interconnection substrate according to one embodiment of the present invention (refer to FIG. 13).
The laser irradiation device 80 is provided with at least a laser beam source 81, a shutter 82, a phase retarder 83, a half mirror 84, an object lens 85, a substrate stage 86, a CCD camera 87, a control computer 88 and a substrate stage control axis 93.

The laser irradiation device 80 is provided with a device that irradiates a linear polarized laser beam 89 that has a pulse width having a pulse duration on the order of picoseconds or shorter to a region provided with a microstructure having a hole shape or a groove shape in a substrate 91, and when forming a modified region 92 by scanning a focal point at which the laser beam 89 is converged, performs laser irradiation while maintaining the orientation R of this linear polarization in a certain direction with respect to the direction of scanning the focal point.

In FIG. 13, the laser beam 89 is irradiated on the substrate 91 that is placed on the substrate stage 86, whereby the modified region 92 is formed. The direction of the arrow along the modified region 92 denotes the scanning direction of the focal point of the laser beam 89. The circle R denotes the orientation of the linear polarization of the laser beam 89 being in the proximal and depth directions on the page. The orientation of the linear polarization of the laser beam 89 is perpendicular to the scanning direction of the laser 89.

As the laser irradiation device 80, it is possible to use a publicly known device that can irradiate the linear polarized laser beam 89 that has a pulse width having a pulse duration on the order of picoseconds or shorter.

The phase retarder 83 that is a part of the device is controlled by the control computer 88, and can adjust the orientation R of the linear polarization of the laser beam 89 that is irradiated to the desired direction. Accordingly, this phase retarder 83 functions so as to make the orientation R of the linear polarization of the laser beam 89 conform to a certain direction in accordance with a change of the scanning direction of the focal point.

In the substrate stage 86 that is another part of the device, it is possible as one chooses to adjust the orientation, angle and movement of the substrate 91 that is fixed on the substrate stage 86 by the substrate stage control axis 93 that is connected to the lower portion of the substrate 86. Accordingly, this substrate stage 86, in accordance with a change in the scanning direction of the focal point, functions so as to make the orientation R of the linear polarization of the laser beam 89 with respect to the scanning direction after this change conform to a given direction according to a change of the scanning direction of the focal point.

The substrate stage 86 that is provided with the substrate stage control axis 93 can as one chooses adjust the orientation, angle and movement of the substrate 91 in synchronization with the change in the scanning direction of the focal point. For example, when changing the scanning direction of the focal point of the laser beam 89 from the X direction of the substrate 91 (horizontal direction) to the direction X + 90° (vertical direction), by rotating the substrate stage 86 to the direction of X - 90° without changing the orientation R of the linear polarization of the laser beam 89, it is possible to change the scanning direction of the focal point to X + 90° of the substrate 91. By this method, even after this change, it is possible to keep the orientation R of the linear polarization of the laser beam 89 constant with respect to the scanning direction of the focal point.

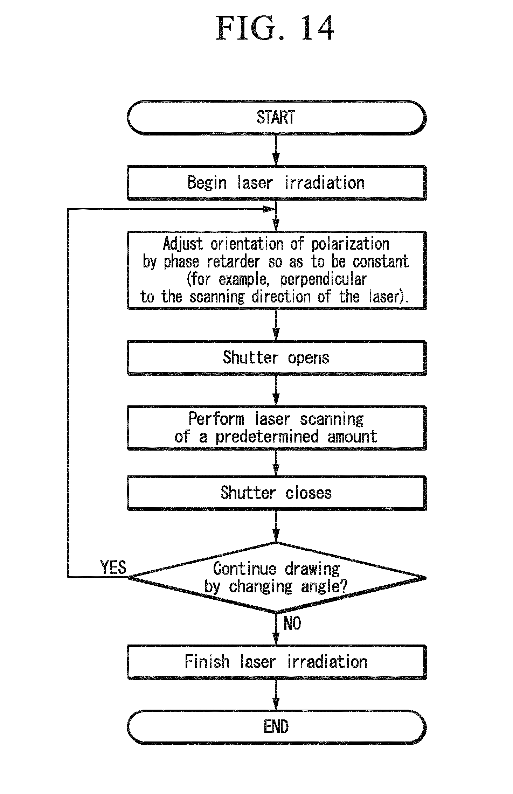

The method of manufacturing the interconnection substrate according to one embodiment of the present invention that uses this laser irradiation device 80 shall be described below with reference to the flowchart of FIG. 14.
First, the substrate 91 is fixed to the substrate stage 86, and information such as the orientation R of the linear polarization of the laser beam 89, the scanning direction, and the scanning region is created as a program that stipulates a series of processes. When the program is started, the phase retarder 83 is adjusted so that the orientation R of the linear polarization is maintained in a certain direction with respect to the scanning direction of the laser beam 89. Thereafter, the shutter 82 opens, and the laser beam 89 of a transparent wavelength with respect to the substrate 91 is irradiated by a predetermined amount at a predetermined position of the substrate 91.

Normally, since the electrons of the material of the substrate 91 are not energized by the bandgap, the laser beam 89 passes through the substrate 91. However, when the photon number of the laser beam 89 becomes extremely numerous, multiphoton absorption occurs, and the electrons are energized, whereby a band-shaped modified region is formed as shown in FIG. 4D and the like.

When the predetermined laser irradiation that is programmed in advance is finished, the shutter 82 is closed. Following this, in the case of continuing the laser drawing by changing the scanning direction of the focal point of the laser beam 89, the phase retarder 83 is again adjusted, and the process is repeated. When the drawing is finished, the laser irradiation is finished, and the process ends.

In the aforementioned method, the phase retarder 83 is adjusted to change the orientation R of the linear polarization of the laser beam 89, and control the relative orientation R of this linear polarization with respect to the scanning direction of the focal point of the laser beam 89.
As another method, it is possible to control to a predetermined orientation the orientation R of this linear polarization with respect to the scanning direction of the focal point of the laser beam 89 by fixing the orientation R of the linear polarization of the laser beam 89 without performing adjustment of the phase retarder 83 as described above, and adjusting the substrate stage control axis 93 to rotate or tilt the stage 86. Also, by combining the adjustment of the phase retarder 83 and the adjustment of the substrate stage 93, the orientation of the linear polarization with respect to the scanning direction of the focal point of the laser beam 89 may be controlled to the desired orientation.

### <Relation of Orientation of Linear Polarization With Respect to Laser Scanning Direction and Etching Speed>

As the result of concerted study, the present inventors arrived at the present invention upon discovering that the orientation of the linear polarization of a laser beam with respect to the scanning direction of the focal point of a laser beam in the modified region formation step (Step A) greatly influences the wet etching speed in the subsequent etching step (Step B). Hereinbelow, a description shall be given with reference to the drawings.

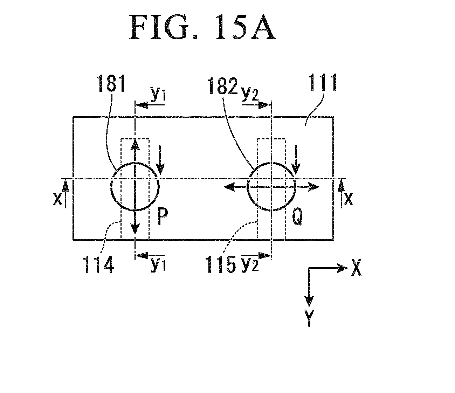

FIG. 15A to FIG. 16D are plan views and cross-sectional views of a substrate 111.

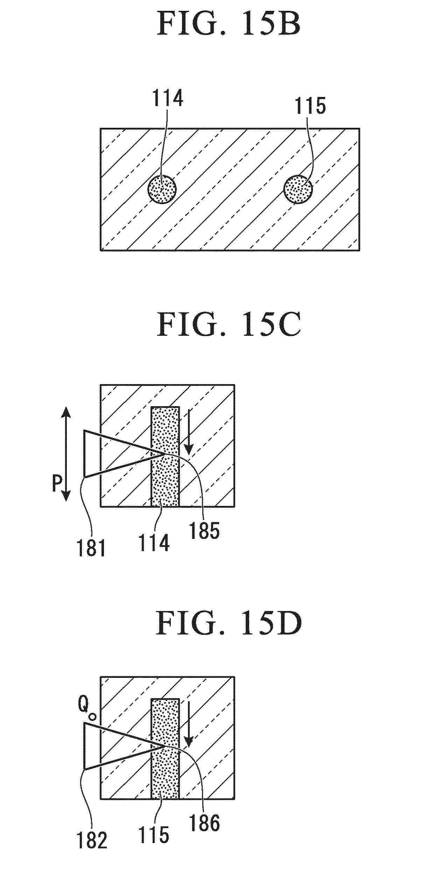

FIG. 15A is a plan view that shows the substrate 111 in the method of forming a microstructure according to one embodiment of the present invention. FIG. 15B is a cross-sectional view along line x-x of FIG. 15A. FIG. 15C is a cross-sectional view along line y1-y1 of FIG. 15A. FIG. 15D is a cross-sectional view along line y2-y2 of FIG. 15A.

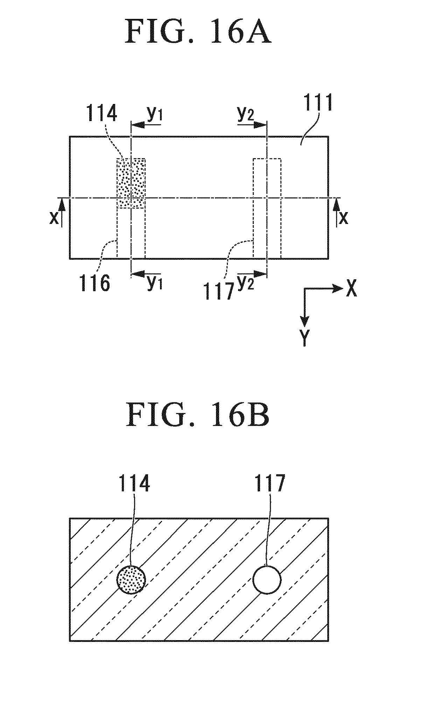

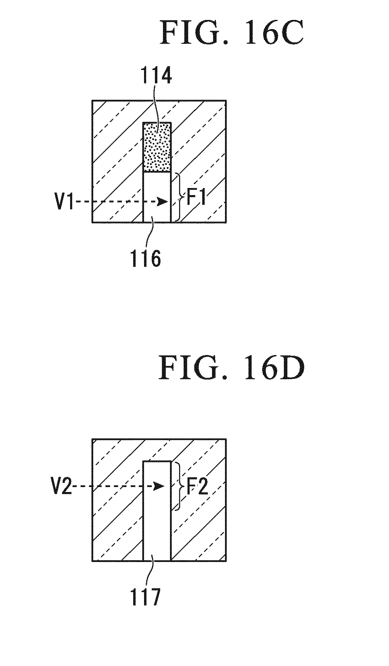

FIG. 16A is a plan view that shows the substrate 111 in the method of forming a microstructure according to one embodiment of the present invention. FIG. 16B is a cross-sectional view along line x-x of FIG. 16A. FIG. 16C is a cross-sectional view along line y1-y1 of FIG. 16A. FIG. 16D is a cross-sectional view along line y2-y2 of FIG. 16A.

In the modified region formation step (Step A), two modified regions that become micro holes are formed by alternating the orientation of the linear polarization of the laser (refer to FIG. 15A to FIG. 15D).
Note that a glass substrate is used as the substrate 111. A femtosecond laser is used as the laser beam source.

First, in the substrate 111, while converging a focal point 185 of a first laser 181 at a region where a first modified region 114 is to be provided, it is scanned. The scanning direction of the focal point 185 is the vertical direction of the substrate 111 (Y direction), and it is performed in a single stroke (single action) as shown by the arrow along the first modified region 114. At this time, the orientation P of the linear polarization of the first laser beam 181 is made the Y direction, the first modified region 114 is formed by keeping it parallel with the scanning direction of the focal point 185.

Moreover, while converging a focal point 186 of a second laser 182 at a region where a second modified region 115 is to be provided, it is scanned. The scanning direction of the focal point 186 is the vertical direction of the substrate 111 (Y direction), and it is performed in a single stroke (single action) as shown by the arrow along the second modified region 115. At this time, the orientation Q of the linear polarization of the second laser beam 182 is made the lateral direction (X direction) of the substrate 111, and so the second modified region 115 is formed by keeping it perpendicular with the scanning direction of the focal point 186.

Next, by immersing the substrate 111 in a hydrofluoric acid solution (10% by mass), and performing wet etching for a predetermined time, the first modified region 114 and the second modified region 115 are removed from the substrate 111, and the first micro hole 116 and the second micro hole 117 that are non-through holes (vias) are formed (refer to FIG. 16A to FIG. 16D).
Upon measuring the depth of each micro hole that was formed, the depth of the first micro hole 116 is approximately 1/2 the depth of the second micro hole 117. That is to say, "first micro hole 116 etching speed/second micro hole 117 etching speed" is approximately 1/2.

Upon observing the inner wall surface of the etched region F1 of the first micro hole 116 and the etched region F2 of the second micro hole 117, which are shown in FIG. 16C and FIG. 16D, from the upper surface of the substrate 111 that is the irradiation direction of the laser beam (from the direction of arrow V1 and arrow V2), banded uneven profiles (stria marks) in respectively different directions are formed.
Note that the circle that is drawn at the portion near the second laser 182 shown in FIG. 15D expresses that the orientation Q of the linear polarization is in the proximal and depth directions on the page.

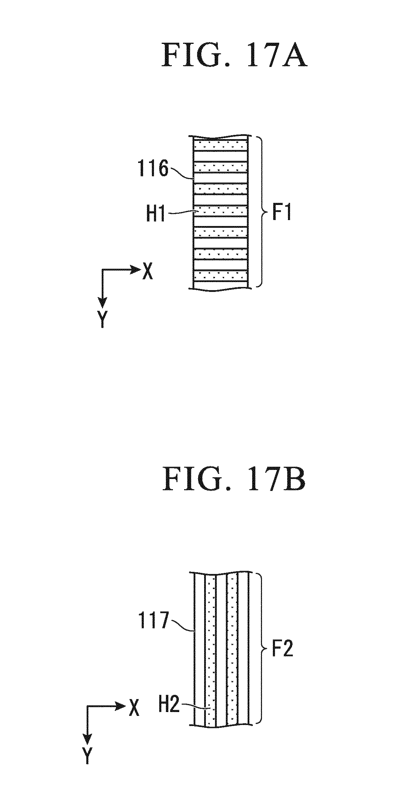

The direction of extension of the banded uneven profile H01 of the first micro hole 116 is perpendicular with respect to the extension direction of the first micro hole 116, and perpendicular with respect to the orientation P of the linear polarization of the first laser beam 181 (refer to FIG. 17A).
The direction of extension of the banded uneven profile H02 of the second micro hole 117 is parallel with respect to the extension direction of the second micro hole 117, and perpendicular with respect to the orientation Q of the linear polarization of the second laser beam 182 (refer to FIG. 17B).
Note that the number of uneven profiles shown in FIG. 17A and FIG. 17B is not limited to a particular number. This number can be changed by controlling the conditions of use of the laser beams that are used and the extent of linear polarization.

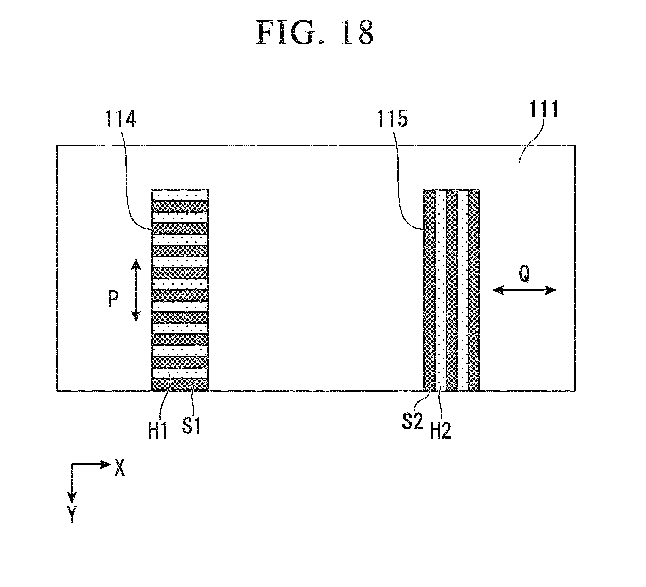

From these results, when viewing the first modified region 114 that is formed in the substrate 111 before etching in the direction of irradiation of the first laser beam 181 from the upper surface of the substrate 111, it is understood that easy to etch (fast etching speed) areas S1 and hard to etch (slow etching speed) areas H1 are alternately formed perpendicular to the scanning direction of the first laser beam 181 (Y direction) and perpendicular to the orientation P of the linear polarization of the first laser beam 181 (Y direction) (refer to FIG. 18).

Also, when viewing the second modified region 115 in the direction of irradiation of the second laser beam 182 from the upper surface of the substrate 111, it is understood that easy to etch (fast etching speed) areas S2 and hard to etch (slow etching speed) areas H2 are alternately formed parallel to the scanning direction of the second laser beam 182 (Y direction) and perpendicular to the orientation Q of the linear polarization of the second laser beam 182 (X direction) (refer to FIG. 18).
Note that the number of respective areas shown in FIG. 18 is not limited to a particular number. This number can be changed by controlling the conditions of use of the laser beams that are used and the extent of linear polarization.

From the above, the following was understood.
In the first modified region 114, when the etching solution progresses to the interior of the substrate 111, the progress of the etching solution is obstructed by the plurality of hard to etch areas H1. On the other hand, in the second modified region 115, when the etching solution progresses to the interior of the substrate 111, the easy to etch areas S2 are removed first, and so the etching solution reaches deep into the second modified region 115. Thereafter, the plurality of hard to etch areas H2 are simultaneously etched in parallel by the etching solution that has replaced the regions where the already removed areas S2 were.
For this reason, the etching speed of the first modified region 114 is slower than the etching speed of the second modified region 115. The etching speed of the second modified region 115 is faster than the etching speed of the first modified region 114.

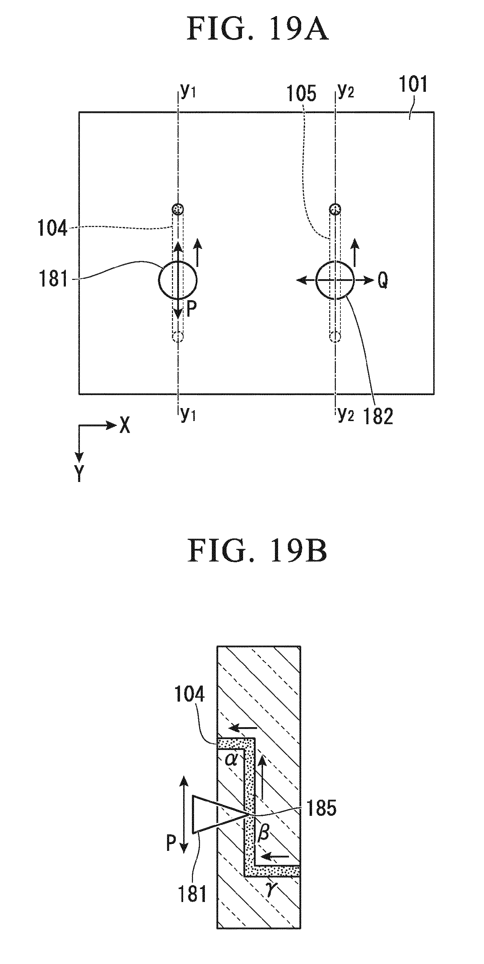

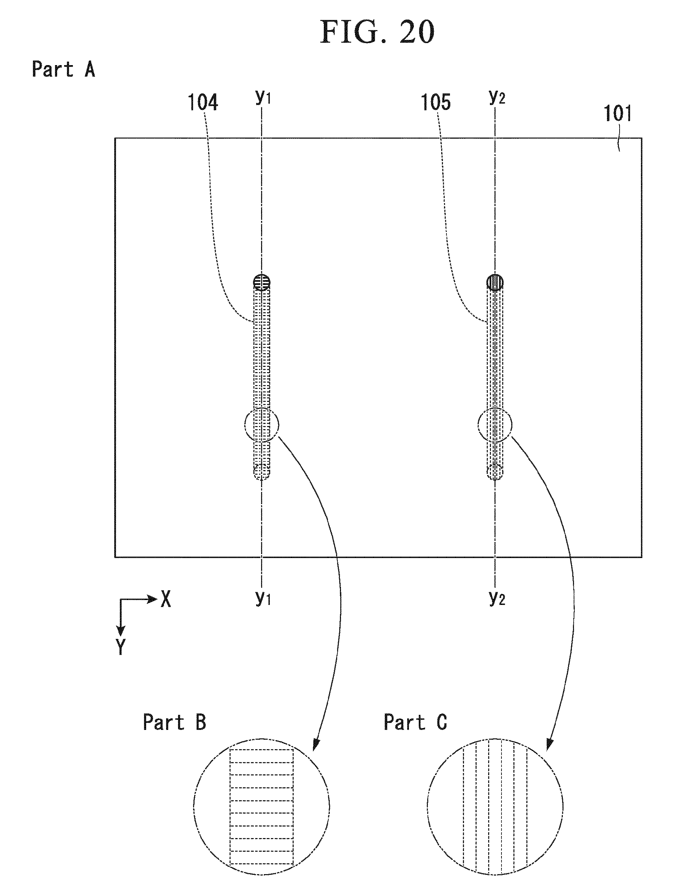

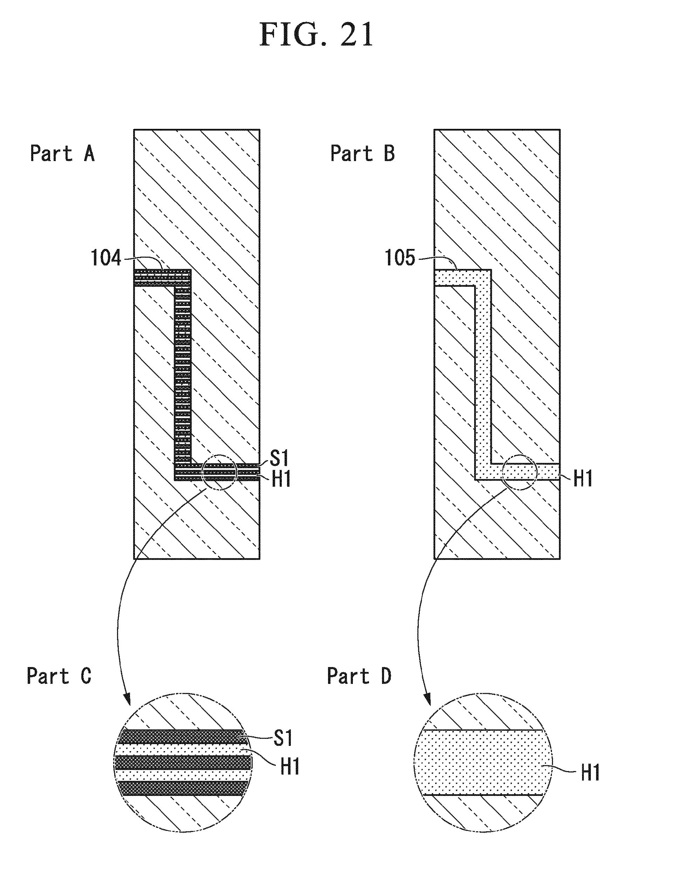

Next, applying the aforementioned understanding to the first modified region 104 and the second modified region 105 with more complicated shapes that are arranged in a separate substrate 101 shown in FIG. 19A to FIG. 19C shall be described.
FIG. 19A to FIG. 22C are plan views and cross-sectional views of the substrate 101.

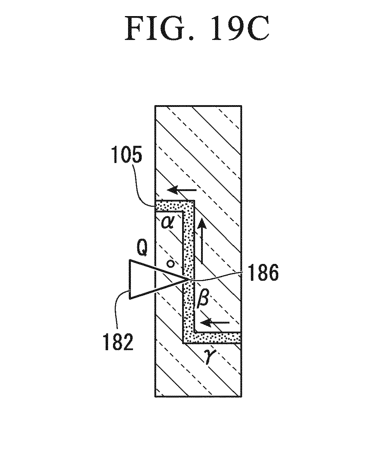

FIG. 19A is a plan view that shows the substrate 101 in the method of forming a microstructure according to one embodiment of the present invention. FIG. 19B is a cross-sectional view along line y1-y1 of FIG. 19A. FIG. 19C is a cross-sectional view along line y2-y2 of FIG. 19A.
Part A of FIG. 20 is a plan view that shows the substrate 101 in the method of forming a microstructure according to one embodiment of the present invention. Part B of FIG. 20 is a close-up view of the first modified region 104. Part C of FIG. 20 is a close-up view of the second modified region 105.
Part A of FIG. 21 is a cross-sectional view along line y1-y1 of FIG. 20. Part B of FIG. 21 is a cross-sectional view along line y2-y2 of FIG. 20. Part C of FIG. 21 is a close-up view of Part A of FIG. 21. Part D of FIG. 21 is a close-up view of Part B of FIG. 21.

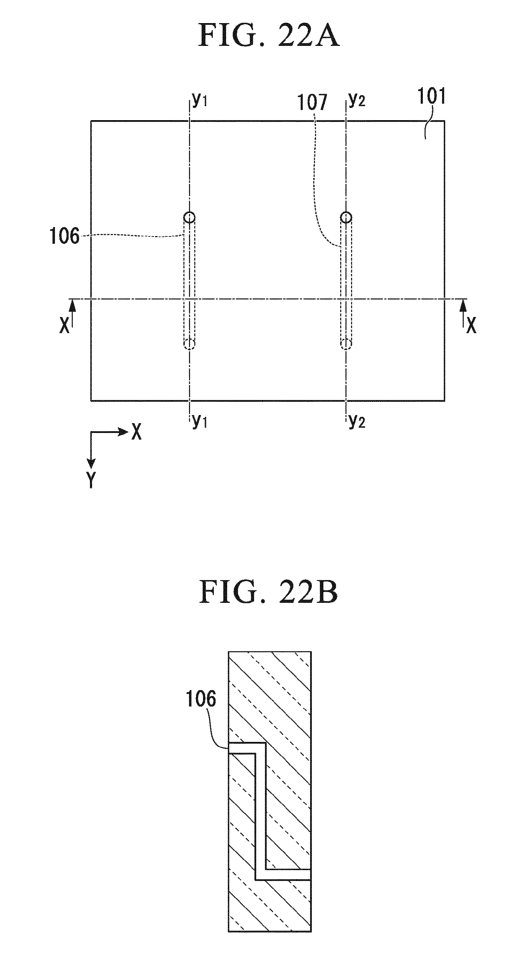

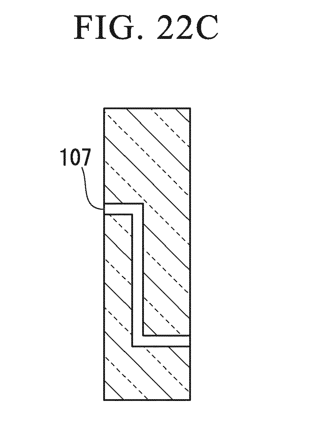

FIG. 22A is a plan view that shows the substrate 101 in the method of forming a microstructure according to one embodiment of the present invention. FIG. 22B is a cross-sectional view along line y1-y1 of FIG. 22A. FIG. 22C is a cross-sectional view along line y2-y2 of FIG. 22A.

First, in the substrate 101, the first laser beam 181 is irradiated from the upper surface of the substrate 101 while converging the focal point 185 of the laser beam 181 at the region where the first modified region 104 is to be formed. The direction of scanning the focal point 185 is the vertical direction of the substrate 101 (Y direction) and the substrate thickness direction. As shown by the arrows along the first modified region 104, the scanning is performed in a single stroke (single action) in the order of a region γ, a region β, and a region α. In the region γ and the region α, the modified region 104 is formed by keeping the orientation P of the linear polarization of the first laser beam 181 perpendicular to the scanning direction of the focal point 185 (the thickness direction of the substrate 101). In contrast, in the region β, the first modified region 104 is formed by keeping the orientation P of the linear polarization of the first laser beam 181 parallel to the scanning direction of the focal point 185 (Y direction) (refer to FIG. 19A to FIG. 19C).

As a result, in the region α and the region γ of the first modified region 104, easy to etch areas S1 and hard to etch areas H1 are formed running side-by-side, parallel with the extension direction of the first modified region 104 (that is to say, the substrate thickness direction). In contrast, in the region β of the first modified region 104, the easy to etch areas S1 and hard to etch areas H1 are formed in an alternating manner perpendicular to the extension direction of the first modified region 104 (that is to say, the Y direction) (refer to FIG. 20 and FIG. 21).
Note that the number of respective areas shown in FIG. 20 and FIG. 21 is not limited to a particular number. This number can be changed by controlling the conditions of use of the laser beams that are used and the extent of linear polarization.

Moreover, in the substrate 101, the second laser beam 182 is irradiated from the upper surface of the substrate 101 while converging the focal point 186 of the laser beam 182 at the region where the second modified region 105 is to be formed. The direction of scanning of the focal point 186 is the vertical direction of the substrate 101 (Y direction) and the substrate thickness direction. As shown by the arrows along the second modified region 105, the scanning is performed in a single stroke (single action) in the order of a region γ, a region β, and a region α. At this time, consistently in the regions α to γ, the second modified region 105 is formed by keeping the orientation Q of the linear polarization of the second laser beam 182 perpendicular to the scanning direction of the focal point 186 (Y direction or substrate thickness direction) (refer to FIG. 19A to FIG. 19C).
Note that the circle that is drawn at the position near the second laser 182 shown in FIG. 19C expresses that the orientation Q of the linear polarization is in the proximal and depth directions on the page.

As a result, consistently throughout the region α, the region β, and the region γ of the second modified region 105, easy to etch areas S2 and hard to etch areas H2 are formed running side-by-side, and parallel along the extension direction of the second modified region 105 (Y direction or substrate thickness direction) (refer to FIG. 20 and FIG. 21).

Note that the shapes of the first modified region 104 and the second modified region are the same. The length of the region α is about 50 µm. The length of the region β is 200 µm. The length of the region γ is about 50 µm.
Also, the substrate 101 is made of glass. As the laser beam source, a femptosecond laser is used.

Next, wet etching is performed by immersing the substrate 101 in an HF solution (10% by mass), and by removing the first modified region 104 and the second modified region 105 from the substrate 101 to pass therethrough, the first micro hole 106 and the second micro hole 107 are formed (refer to FIG. 22A to FIG. 22C). At this time, the penetration times (etching speed) by removal of the first modified region 104 and the second modified region 105 were measured. As a result, "etching speed of the first modified region 104/etching speed of the second modified region 105" was approximately 3/5. The etching speeds of the region α and the region γ were the same in both modified regions. In contrast, the etching speed of the region β in the first modified region 104 was approximately twice as fast as that of the second modified region 105. The aforementioned result is due to this.

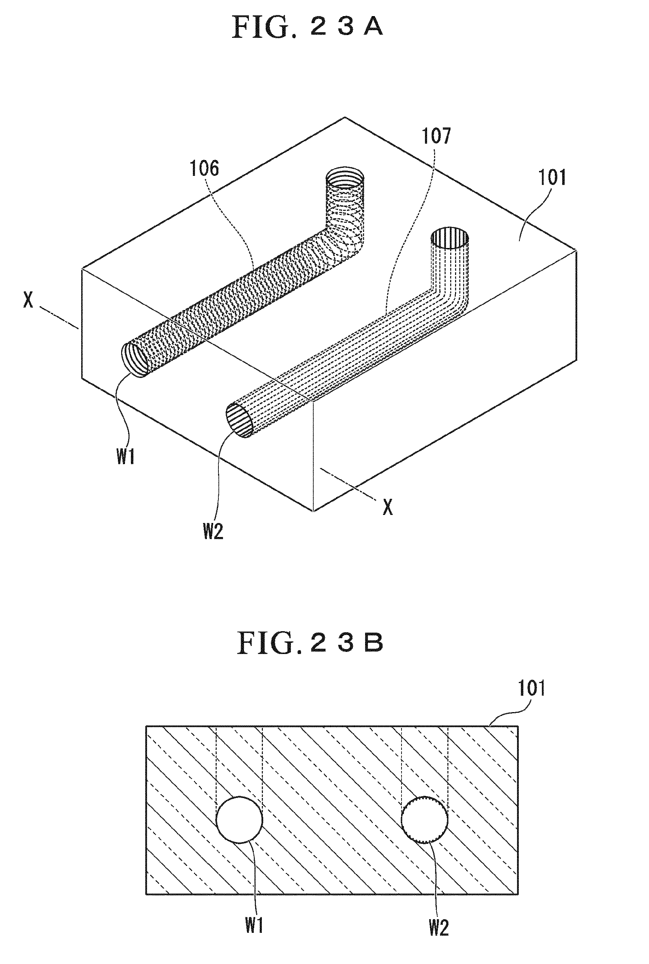

Also, on the inner wall surface of the first micro hole 106, a banded uneven profile is formed so that the ring-like unevenness lies in a perpendicular direction with respect to the extension direction of this micro hole (FIG. 23A and FIG. 23B). In contrast, on the inner wall surface of the first micro hole 107, a banded uneven profile is formed so that a plurality of linear unevennesses advance side-by-side along the extension direction of this micro hole (refer to FIG. 23A and FIG. 23B).
Note that FIG. 23A is a perspective view that shows a cross-section along the line x-x of FIG. 22A. FIG. 23B is a cross-sectional view along line x-x of FIG. 22A. In FIG. 23A and FIG. 23B, W1 denotes the cross-section of the first micro hole 106 in FIG. 22A to FIG. 22C, and W2 denotes the cross section of the second micro hole 107.
Note that the number of uneven profiles shown in FIG. 23A and FIG. 23B is not limited to a particular number. This number can be changed by controlling the conditions of use of the laser beams that are used and the extent of linear polarization.

From the above, it was found that in the case of forming a modified region in a region in which a microstructure such as a micro hole or a micro groove is provided, the etching speed is constant in all regions of the microstructure by scanning the focal point of this laser beam while keeping the orientation of the linear polarization of the laser beam being irradiated constant with respect to the direction of extension of this microstructure (for example, parallel or perpendicular). For this reason, even in the case of forming a plurality of microstructures of a predetermined shape in the substrate, it is possible to make uniform the etching speed of the microstructures, and it is possible to perform etching of the microstructures to be formed with no excess or deficiency. In particular, in the case of performing laser irradiation while keeping the orientation of the linear polarization perpendicular with respect to the direction of extension of this microstructure, it is possible to maximize the etching speed of this microstructure, and so is preferred.

### <Substrate Having A Micro Hole>

In the substrate that has a micro hole of the present embodiment, a banded uneven profile along the extension direction of the micro hole is formed at at least one portion of the inner wall surface of this micro hole.
Examples of the material of this substrate include glass, sapphire, and silicon.
This banded uneven profile may be formed on all surfaces of the inner wall face of this micro hole, or may be formed on only a portion. This banded uneven profile (stria) is formed along the extension direction of this micro hole, or approximately parallel with the extension direction of this micro hole.
A specific example of a substrate that has the micro hole of the present embodiment includes the aforementioned interposer substrate 10 and the surface interconnection substrate 30.

The same effect is obtained even with a substrate that is obtained by another manufacturing method, without being limited to a substrate that is obtained by the same method as the method of manufacturing the aforementioned interposer substrate 10 and the surface interconnection substrate 30. That is to say, the substrate should be a substrate that has the micro hole (through hole), and in which a banded uneven profile along the extension direction of this micro hole (uneven profile approximately parallel with the extension direction of the micro hole) is formed in at least a portion of the inner wall surface of the micro hole. That is to say, even if it is a substrate that is manufactured by a method that differs from the aforementioned manufacturing method, provided the obtained substrate is the same, the same effect is obtained.

### INDUSTRIAL APPLICABILITY

The method of forming a microstructure of the present invention, and the laser irradiation device that is used in this method can be suitably used for manufacturing an interconnection substrate that is used for integrated circuits of electronic components.

### DESCRIPTION OF THE REFERENCE SYMBOLS

1: substrate
2: one principal surface
3: other principal surface
4: first micro hole
5: second micro hole
6: conductive substance
7: first through-hole interconnection
8: second through-hole interconnection
9: opening portion
10: interposer substrate
11: bend portion
12: bend portion
13: opening portion
14: opening portion
15: bend portion
16: bend portion
17: opening portion
30: surface interconnection substrate
31: substrate
32: one principal surface
33: other principal surface
34: first micro hole
36: conductive material
37: first surface interconnect
38: one end portion
39: bend portion
40: other end portion
51: first laser beam
52: second laser beam
53: first modified region
53s: easy to etch area
53h: hard to etch area
54: second modified region
56: first focal point
57: second focal point
59: etching solution
61: third laser beam
62: third modified region
62s: easy to etch area
62h: hard to etch area
63: third focal point
65: third laser light
66: second modified region
66s: easy to etch area
66h: hard to etch area
67: third focal point
68: fourth laser beam
69: third modified region
69s: easy to etch area
69h: hard to etch area
70: fourth focal point
71: first laser beam
72: second laser beam
73: first modified region
73s: easy to etch area
73h: hard to etch area
74: focal point
75: focal point
77: etching solution
80: laser irradiation device
81: laser light source
82: shutter
83: phase retarder
84: half mirror
85: object lens
86: substrate stage
87: CCD camera
88: computer
89: laser beam
91: substrate
92: modified region
93: substrate stage control axis
P: orientation of linear polarization of first laser beam
Q: orientation of linear polarization of second laser beam
R: orientation of linear polarization of third laser beam
101: substrate
102: first modified region
103: second modified region
105: second modified region
106: first micro hole
107: second micro hole
111: substrate
114: first modified region
115: second modified region
116: first micro hole
117: second micro hole
181: first laser beam
182: second laser beam
185: focal point
186: focal point
S 1: easy to etch area
H1: hard to etch area
g1: third micro hole
g2: first micro hole
g3: second micro hole
G1: fluidic channel
G2: first fluidic channel
G3: second fluidic channel
H01: banded uneven profile
H02: banded uneven profile.

## Claims

1. A method of forming a microstructure comprising:
a Step (A) of forming a modified region in a substrate by irradiating a laser beam having a pulse duration on the order of picoseconds or shorter on a region where a pore-like microstructure is to be provided, and scanning a focal point at which the laser beam is converged; and
a Step (B) of forming a microstructure by performing an etching process on the substrate in which the modified region has been formed, and removing the modified region, wherein:
a linear polarized laser beam is used as the laser beam in the Step (A); and
the laser beam is irradiated so that an orientation of a linear polarization has a certain direction with respect to a direction of scanning the focal point.

2. The method of forming a microstructure according to claim 1, wherein the certain direction is a direction that is perpendicular to the direction of scanning the focal point.

3. A laser irradiation device comprising a device that, when forming a modified region in a substrate by irradiating a linear polarized laser beam having a pulse duration on the order of picoseconds or shorter at a region where a pore-like microstructure is to be provided, and scanning a focal point at which the laser beam is converged, irradiates the laser beam so that an orientation of a linear polarization has a certain direction with respect to a direction of scanning the focal point.

4. The laser irradiation device according to claim 3, wherein:
the device is a phase retarder; and
the phase retarder, in response to a change in the scanning direction of the focal point, functions so as to cause the orientation of the linear polarization of the laser beam with respect to the scanning direction after the change to match a certain direction.

5. The laser irradiation device according to claim 3 or 4, wherein:
the device is a substrate stage; and
the substrate stage, in response to a change in the scanning direction of the focal point, functions so as to cause the orientation of the linear polarization of the laser beam with respect to the scanning direction after the change to match a certain direction.

6. A substrate that is manufactured using the method of forming a microstructure according to claim 1 or 2,
comprising a section in which a banded uneven profile is formed on an inner wall surface of the microstructure.

7. The substrate according to claim 6, comprising a fluidic channel through which a fluid circulates in an interior thereof.

8. A substrate with a micro hole,
wherein a banded uneven profile is formed along an extension direction of the micro hole at at least a portion of an inner wall surface of the micro hole.
